# EUROPÄISCHE PATENTSCHRIFT

(11) **EP 2 267 800 B1**
(45) Veröffentlichungstag und Bekanntmachung des Hinweises auf die Patenterteilung: **12.07.2017**
(21) Anmeldenummer: 10183569.2
(22) Anmeldetag: 08.08.2001
(51) Int. Cl.: H01L 33/00, H01L 33/20, H01L 33/08, H01L 33/10

(54) **Lichtemittierender Halbleiterchip und Verfahren zu dessen Herstellung**
Semiconductor chip for optoelectronics and method for producing same
Puce semi-conductrice pour l'optoélectronique et son procédé de fabrication

(30) Priorität: 08.08.2000 DE 10038671; 30.11.2000 DE 10059532
(43) Veröffentlichungstag der Anmeldung: 29.12.2010
(62) Teilanmeldung aus: 01984505.6
(73) Patentinhaber: OSRAM Opto Semiconductors GmbH, 93055 Regensburg (DE)
(72) Erfinder: Illek, Stefan, 93093 Donaustauf (DE); Wirth, Ralph, 93098 Mintraching - Auhof (DE); Wegleiter, Walter, 93152 Nittendorf (DE); Plößl, Andreas, 93051 Regensburg (DE); Streubel, Klaus, 93164 Laaber (DE)
(74) Vertreter: Epping - Hermann - Fischer

(56) Entgegenhaltungen:
- EP-A1- 0 977 063
- DE-A1- 2 716 205
- JP-A- 6 318 731
- US-A- 3 813 587

## Beschreibung

Die Erfindung betrifft einen Halbleiterchip für die Optoelektronik, insbesondere einen strahlungsemittierenden Halbleiterchip, mit
- einer aktiven Dünnfilmschicht in der eine Photonen emittierende Zone ausgebildet ist und
- einem Trägersubstrat für die Dünnfilmschicht, das an einer von der Abstrahlrichtung des Chips abgewandten Seite der Dünnfilmschicht angeordnet und mit dieser verbunden ist.
Sie betrifft weiterhin ein Verfahren zum gleichzeitigen Herstellen einer Mehrzahl von derartigen Halbleiterchips.
Das Trägersubstrat ist Teil des Halbleiterchips an sich und mechanische Stütze für die Dünnfilmschicht, d. h. das wesentliche tragende Element für die Dünnfilmschicht, die selbst auf der dem Trägersubstrat gegenüberliegenden Seite keine selbsttragende Schicht mehr aufweist.
Dünnfilmschicht auf der Basis von In_{1-x-y}AlₓGa_{y}P (wobei 0≤x≤1, 0≤y≤1 und x+y≤1 ist) bedeutet, dass die Dünnfilmschicht eine Mehrzahl von Schichten aufweist, die aus dotiertem oder undotiertem Material aus dem System In_{1-x-y}AlₓGa_{y}P (wobei 0≤x≤1, 0≤y≤1 und x+y≤1 ist) hergestellt sind. US3,813,587 offenbart eine Licht-emittierende Diode mit einer aktiven Dünnfilmschicht welche auf eine Aufwachssubstrat gebildet ist. Halbleiterchips der eingangs genannten Art sind aus der US 5,008,718 und US 5,367,580 bekannt. Zur Herstellung eines Halbleiterchips des bekannten Typs wird üblicherweise eine aktive Halbleiterschichtenfolge auf einem Substrat durch ein Epitaxieverfahren aufgebracht. Auf der Oberseite der aktiven Halbleiterschichtenfolge wird daraufhin ein Trägersubstrat befestigt. Das Substrat, auf dem die Halbleiterschichtenfolge abgeschieden worden ist, wird zumindest teilweise entfernt. Vorteilhafterweise befindet sich zwischen dem Trägersubstrat und der aktiven Halbleiterschichtenfolge eine metallische Reflexionsschicht, so dass kein Licht vom Trägersubstrat absorbiert wird.

Ein Nachteil der bekannten Halbleiterchips ist, dass die zwischen Trägersubstrat und der aktiven Halbleiterschichtenfolge angeordnete metallische Reflexionsschicht bei kurzen Wellenlängen im Allgemeinen keine zufriedenstellende Reflektivität aufweist. Insbesondere bei einer Wellenlänge von weniger als 600 nm wird Gold als metallische Reflexionsschicht immer ineffizienter, da die Reflektivität signifikant abnimmt. Bei Wellenlängen unterhalb von 600 nm können beispielsweise die Elemente Al und Ag verwendet werden, deren Reflektivität bei Wellenlängen kleiner 600 nm vergleichsweise konstant bleibt.

Außerdem bereitet das Bonden von großen Flächen, wie die metallische Reflexionsschicht Schwierigkeiten. Durch das Bonden und das Legieren der metallischen Kontaktschicht besteht außerdem eine erhebliche Gefahr für eine Beeinträchtigung der Qualität der metallischen Reflexionsschicht.

Weiter ist aus der DE 198 07 758 A1 ein pyramidenstumpfförmiger Halbleiterchip bekannt, der eine aktive, Licht emittierende Zone zwischen einer oberen Fensterschicht und einer unteren Fensterschicht aufweist. Die obere Fensterschicht und die untere Fensterschicht bilden zusammen einen pyramidenstumpfförmigen Grundkörper. Die schräge Ausrichtung der Seitenwände der Fensterschichten bewirkt, dass das von der aktiven Zone ausgehende Licht an den Seitenflächen totalreflektiert wird und nahezu rechtwinklig auf die als Leuchtfläche dienende Basisfläche des pyramidenstumpfförmigen Grundkörpers auftrifft. Dadurch tritt ein Teil des von der aktiven Zone emittierten Lichts innerhalb des Austrittkegels des Halbleiterelements auf die Oberfläche.
Unter Austrittskegel ist hierbei und soll auch im Folgenden der Kegel zu verstehen, der aus Lichtstrahlen gebildet wird, deren Einfallswinkel auf die Austrittsfläche kleiner als der kritische Winkel für die Totalreflexion ist und die daher nicht totalreflektiert sondern unmittelbar aus dem Halbleitermaterial ausgekoppelt werden. Der Öffnungswinkel des Austrittskegels ist folglich doppelt so groß wie der Grenzwinkel der Totalreflexion. Diejenigen Lichtstrahlen, die außerhalb des Austrittskegels verlaufen, also in einem größeren Winkel als der Grenzwinkel der Totalreflexion auf die Austrittsfläche treffen, werden totalreflektiert.
Um zu einer signifikanten Steigerung der Lichtausbeute zu kommen, setzt dieses Konzept eine Mindestdicke für die obere und untere Fensterschicht voraus. Bei dem bekannten pyramidenstumpfförmigen Halbleiterelement beträgt die Dicke der oberen und unteren Fensterschicht wenigstens 50,8 µm (2 Millizoll). Eine derartige Schichtdicke ist noch im Bereich des Machbaren. Falls jedoch die Leistung des bekannten Halbleiterchips erhöht werden soll, ist es erforderlich, sämtliche Abmessungen zu skalieren. Dabei ergeben sich rasch Schichtdicken, die nur unter hohem Aufwand auf epitaktischem Wege herstellbar sind. Dieser bekannte Halbleiterchip ist daher wenn überhaupt dann nur mit großem technischem Aufwand skalierbar.
Ausgehend von diesem Stand der Technik liegt der Erfindung die Aufgabe zugrunde, einen in Dünnfilmtechnik herstellbaren Halbleiterchip mit verbesserter Lichtauskopplung zu schaffen und ein Verfahren zu dessen Herstellung anzugeben.

Bei einem Beispiel des Halbleiterchips nimmt der Querschnitt der Kavität von Außen nach Innen, das heißt von der Grenze zum Trägersubstrat zum Inneren der Dünnfilmschicht hin ab und beträgt die Tiefe der Kavität mehr als die Hälfte der Dicke der Dünnfilmschicht.
Die Kavität beziehungsweise die durch diese hergestellte Mehrzahl von Mesen bewirkt einerseits vorteilhafterweise, dass die Dünnfilmschicht an ihrer Verbindungsseite zum Trägersubstrat hin Anpressflächen aufweist, die gegenüber der Gesamtquerschnittsfläche des Chips kleinflächig sind. Dies bringt den Vorteil mit sich, dass im Bereich dieser verkleinerten Anpressflächen ein vergleichsweise großer lokaler Druck erzeugt werden kann - dieser ist für ein sicheres Verbinden von Trägersubstrat und Dünnfilmschicht förderlich - und gleichzeitig aber der Druck auf die Dünnfilmschicht ausreichend gering gehalten werden kann, um die Gefahr einer Schädigung der Dünnfilmschicht beim Verbinden mit dem Trägersubstrat so weit wie möglich auszuschließen.
Andererseits wird die zur Verfügung stehende Verbindungsfläche aufgrund der Kavität vergrößert, was ebenfalls zur Verbesserung der Verbindung zwischen Trägersubstrat und Dünnfilmschicht führen kann. Überdies steht die Kavität zur Aufnahme von überschüssigem Klebstoff oder Lötmaterial zur Verfügung, was deren Dosierung vorteilhafterweise weniger kritisch macht.
Durch die Kavität werden außerdem vorteilhafterweise Seitenflächen geschaffen, an denen ein Teil der von der aktiven Zone emittierten Strahlung so umgelenkt wird, dass sie innerhalb des Austrittkegels auf die vom Trägersubstrat abgewandte Austrittsfläche der aktiven Dünnfilmschicht auftreffen. Gegenüber dem Stand der Technik tritt bei dem hier beschriebenen Halbleiterchip die Reflexion an den Seitenflächen der Mesen zumindest teilweise an die Stelle der Reflexion an einer durchgehenden ebenen Reflexionsschicht. Dabei ist es vorteilhaft, wenn die Seitenflächen möglichst tief in die Dünnfilmschicht hineinragen, damit ein möglichst großer Anteil der von der aktiven Zone emittierten Strahlung, der nicht unmittelbar auf die Austrittfläche trifft und dort ausgekoppelt wird, derart (eventuell sogar mehrfach) reflektiert, das heißt umgelenkt wird, dass er mit einem Winkel auf die Austrittsfläche trifft, der innerhalb des Austrittskegels liegt.
Untersuchungen zeigen, dass die Auskoppeleffizienz stark ansteigt, wenn die Tiefe der Kavität größer als die Hälfte der Dicke der Dünnfilmschicht ist.

Bei einem Beispiel ist die Kavität so tief, dass die aktive Zone der aktiven Dünnfilmschicht von ihr durchtrennt ist.
Es hat sich gezeigt, dass Halbleiterchips, deren aktive Zone durch eine in die aktive Dünnfilmschicht von der Befestigungsseite her eingebrachte Kavität unterbrochen ist, eine besonders hohe Lichtausbeute aufweisen. Denn in diesem Fall werden nicht nur die zur Befestigungsseite hin emittierten Photonen, sondern auch zumindest ein Teil der zur Austrittsfläche der aktiven Dünnfilmschicht hin emittierten Photonen durch Reflexion an den Seitenflächen der Mesen in einen Winkel zur Austrittsfläche umgelenkt, der innerhalb des Austrittskegels liegt.
Die Reflexion an den Begrenzungsflächen der Mesen bewirkt, dass ein Großteil der von der aktiven Zone emittierten Photonen innerhalb des Austrittskegels auf die Austrittsfläche auftrifft und den Halbleiterchip verlassen kann.

Bei einem weiteren Beispiel ist die Dünnfilmschicht so ausgebildet, dass wenigstens eine Trajektorie der von der aktiven Zone emittierten Photonen von der jeweiligen Mesa zu einer der benachbarten Mesen führt.

Durch die optische Kopplung der Mesen können Photonen, die nicht an einer der Seitenflächen der ursprünglichen Mesa reflektiert worden sind, in eine der benachbarten Mesen gelangen und dort an den Seitenflächen der jeweiligen Mesa so reflektiert werden, dass sie innerhalb des Austrittskegels auf die Austrittsfläche treffen.

Ferner sind bei einem Beispiel die Mesen mit konkaven Seitenflächen ausgestattet. Durch diese Maßnahmen verlaufen Strahlen, die an der Austrittsfläche zunächst reflektiert werden mit jeder weiteren Reflexion an einer Seitenfläche einer Mesa zunehmend steiler zur Austrittsfläche, so dass sie schließlich innerhalb des Austrittskegels auf die Austrittsfläche treffen.
Bei einer weiteren bevorzugten Ausführungsform sind die Mesen mit einer Reflexionsschicht bedeckt.
Durch diese Maßnahme werden sämtliche auf die Seitenfläche der Mesen treffenden Lichtstrahlen in Richtung auf die Austrittsseite des Halbleiterchips gelenkt.

Ferner betreffen Beispiele Aspekte und Kombinationen von Aspekten, die nummeriert angegeben sind:
1. Halbleiterchip für die Optoelektronik, insbesondere strahlungsemittierender Halbleiterchip, mit
   - einer aktiven Dünnfilmschicht (2), in der eine Photonen emittierende Zone (3) ausgebildet ist; und
   - einem Trägersubstrat (1) für die Dünnfilmschicht (2), das an einer von der Abstrahlrichtung des Chips abgewandten Seite der Dünnfilmschicht (2) angeordnet und mit dieser verbunden ist,
   wobei
   - in der aktiven Dünnfilmschicht (2) vom Trägersubstrat (1) her mindestens eine Kavität (8) ausgebildet ist, durch die an der Grenze zwischen Trägersubstrat (1) und Dünnfilmschicht (2) eine Mehrzahl von Mesen (4) ausgebildet ist.
2. Halbleiterchip nach Aspekt 1,
   wobei
   - der Querschnitt der Kavität (8) im Verlauf vom Trägersubstrat (1) weg kleiner wird.
3. Halbleiterchip nach Aspekt 1 oder 2,
   wobei
   - die aktive Dünnfilmschicht eine Schichtenfolge aufweist.
4. Halbleiterchip nach Aspekt 1,
   wobei
   - die Kavitäten (8) derart tief ausgebildet sind, dass sie die aktive Zone (3) durchtrennen.
5. Halbleiterchip nach einem der vorhergehenden Aspekte,
   wobei
   - durch eine Mehrzahl von Kavitäten (8) nur in denjenigen Bereichen, welche die strahlungserzeugenden Bereiche der Dünnfilmschicht (2) darstellen, Mesen (4) ausgebildet sind.
6. Halbleiterchip nach einem der vorhergehenden Aspekte,
   wobei
   - wenigstens eine Trajektorie (18) der von der aktiven Zone (3) emittierten Photonen von der jeweiligen Mesa (4) zu einer der benachbarten Mesen (4) führt.
7. Halbleiterchip nach Aspekt 5 oder 6,
   wobei
   - sich die Mesen (4) zum Trägersubstrat hin verjüngen.
8. Halbleiterchip nach Aspekt 7,
   wobei
   - die Mesen (4) konkave Seitenflächen (13) aufweisen.
9. Halbleiterchip nach einem der Aspekte 5 bis 8,
   wobei
   - die Mesen (4) pyramidenstumpfförmig ausgebildet sind.
10. Halbleiterchip nach einem der Aspekte 5 bis 9,
   wobei
   - die aktive Zone (3) in einer der Deckschicht (5) benachbarten Hälfte der Mesen (4) angeordnet ist.
11. Halbleiterchip nach einem der Aspekte 5 bis 10,
   wobei
   - die Deckschicht (5) für die von der aktiven Zone (3) emittierten Photonen weitestgehend transparent ist.
12. Halbleiterchip nach einem der Aspekte 5 bis 11,
   wobei
   - die Deckschicht (5) hoch dotiert ist.
13. Halbleiterchip nach einem der Aspekte 4 bis 12,
   wobei
   - die Mesen (4) mit einer Reflexionsschicht (9, 10) bedeckt sind.
14. Halbleiterchip nach Aspekt 13,
   wobei
   - die Reflexionsschicht eine mit einer Isolierschicht (9) unterlegte Metallisierungsschicht (10) aufweist.
15. Halbleiterchip nach einem der vorhergehenden Aspekte,
   wobei
   - die aktive Dünnfilmschicht (2) eine Dicke von zwischen 5 µm und 50 µm aufweist.
16. Halbleiterchip nach Aspekt 15,
   wobei
   - die aktive Dünnfilmschicht (2) eine Dicke von zwischen 5 µm und 25 µm aufweist.
17. Halbleiterchip nach einem der vorigen Aspekte,
   wobei
   - die Tiefe der zumindest einen Kavität (8) größer als die Hälfte der Dicke der Dünnfilmschicht (2) ist.
18. Halbleiterchip nach einem der vorigen Aspekte,
   wobei
   - das Trägersubstrat (1) elektrisch leitfähig ist und auf der der Dünnfilmschicht (2) abgewandten Seite eine elektrische Kontaktfläche (44) aufweist.
19. Halbleiterchip nach einem der Aspekte 1 bis 17,
   wobei
   - das Trägersubstrat (1) elektrisch isolierend oder elektrisch leitfähig ist und auf der der Dünnfilmschicht (2) zugewandten Seite neben der Dünnfilmschicht (2) eine elektrische Kontaktfläche (46) aufweist.
20. Halbleiterchip nach einem der vorigen Aspekte,
   wobei
   - die der Befestigungsseite (11) gegenüberliegende Oberfläche (6) der Dünnfilmschicht (2) mit einer optischen Vergütungsschicht (42) zur verbesserten Lichtauskopplung versehen ist.
21. Halbleiterchip nach Aspekt 20,
   wobei
   - die optische Vergütungsschicht (42) aus Siliziumnitrid gebildet ist.
22. Halbleiterchip nach Aspekt 20,
   wobei
   - die optische Vergütungsschicht (42) aus leitfähigem Indium-Zinn-Oxid gebildet ist.
23. Halbleiterchip nach einem der vorigen Aspekte,
   wobei
   - die Dünnfilmschicht (2) im Bereich gegenüber einer oder mehrerer Kontaktstellen (7, 43) keine Kavität (8) aufweist.
24. Halbleiterchip nach einem der vorigen Aspekte,
   wobei
   - sich die Mesen (4) in Richtung zum Trägersubstrat (1) hin verjüngen.
25. Halbleiterchip nach Aspekt 24,
   wobei
   - die Mesen (4) eine pyramidenstumpfartige oder kegelstumpfartige Form haben und die schrägen Seitenflächen einen Anstellwinkel ϕ gegen die laterale Erstreckungsrichtung der Dünnfilmschicht (2) von zwischen 5° und 60°, insbesondere zwischen 10° und 40° aufweist.
26. Halbleiterchip nach Aspekt 25,
   wobei
   - der Anstellwinkel ϕ zwischen 15° und 30° liegt.
27. Verfahren zum gleichzeitigen Herstellen einer Mehrzahl von Halbleiterchips für die Optoelektronik mit einer aktiven Dünnfilmschicht (2), in der eine Photonen emittierende aktive Zone (3) ausgebildet ist, mit den Verfahrensschritten:
   - Epitaktisches Aufwachsen einer die Photonen emittierende Zone (3) enthaltende Schichtenfolge auf einem Aufwachssubstratwafer (20);
   - Ausbilden von zumindest einer Kavität (8) in der Schichtenfolge, derart, dass eine Mehrzahl von Mesen (4) in der Schichtfolge entstehen;
   - Aufbringen von zumindest einer Isolierschicht (9) auf die mit den Kavitäten (8) versehene Oberfläche der Schichtenfolge;
   - Herstellen von jeweils mindestens einer Durchkontaktierung (12) auf den Mesen (4);
   - Aufbringen des Scheibenverbundes aus Aufwachssubstratwafer (20) und Schichtenfolge auf einen Trägersubstratwafer (21) derart, dass die Mesen (4) zum Trägersubstratwafer (21) gewandt sind, und Verbinden des Scheibenverbundes mit dem Trägersubstratwafer (21) insbesondere mittels Löten oder Kleben;
   - Zumindest teilweises Entfernen des Aufwachssubstratwafers (20);
   - Aufbringen einer elektrischen Kontaktierung (7,43,49) auf die den Mesen (4) gegenüberliegenden Seite der Schichtenfolge; und
   - Vereinzeln des Waferverbundes aus Trägersubstratwafer (21) und strukturierter Schichtenfolge entlang von Trennspuren (22) zu Halbleiterchips (23).
28. Verfahren nach Aspekt 27, bei dem
   - vor dem Verbinden der Schichtenfolge mit dem Trägersubstratwafer (21) die Schichtenfolge entlang der Trennspuren (22) durchtrennt wird.
29. Verfahren nach Aspekt 28, bei dem
   - vor dem Verbinden nach dem Entfernen des Aufwachssubstratwafers 20 und vor dem Durchtrennen des Trägersubstratwafers (21) die Schichtenfolge entlang der Trennspuren (22) in einem separaten Schritt durchtrennt wird.

Es zeigen:
- Figur 1: eine schematische Darstellung eines Querschnitts durch einen Halbleiterchip
- Figur 2: eine schematische Darstellung eines Querschnitts durch ein weiteres Ausführungsbeispiel eines Halbleiterchips bei dem die aktive Zone jeweils innerhalb von pyramidenstumpfförmigen Mesen angeordnet ist;
- Figur 3: eine schematische Darstellung eines Querschnitts durch einen Halbleiterchip der mit Mesen ausgestattet ist, die konkave Seitenflächen aufweisen;
- Figur 4: ein Diagramm, das die Steigerung der Lichtausbeute bei dem Halbleiterchips im Vergleich zu herkömmlichen Halbleiterchips zeigt;
- Figur 5: eine schematische Darstellung eines Querschnittsprofils einer Mesa, die sich aus einem unteren flachen Kegelstumpf und einem oberen steilen Kegelstumpf zusammensetzt;
- Figur 6a bis 6d: schematische Darstellungen verschiedener Querschnittsprofile von Mesen und ein Diagramm, das die Abhängigkeit der Auskoppeleffizienz vom Radius der Grenzfläche zwischen dem unteren Pyramidenstumpf und dem oberen Pyramidenstumpf der Mesa aus Figur 5 zeigt;
- Figur 7: ein Diagramm, das die Abhängigkeit der Auskoppeleffizienz von der Reflektivität einer auf der Spitze der Mesa aus Figur 5 angeordneten Kontaktschicht zeigt;
- Figur 8: ein Diagramm, in dem die Abhängigkeit der Auskoppeleffizienz von der Reflektivität der Seitenflächen der Mesa aus Figur 5 dargestellt ist;
- Figur 9: ein Diagramm, aus dem der Zusammenhang zwischen Auskoppeleffizienz und Größe eines Leuchtflecks in der aktiven Zone hervorgeht;
- Figur 10a bis 10d: schematische Darstellungen verschiedener Querschnittsprofile einer Mesa, bei der die Höhe der aktiven Zone variiert ist und ein Diagramm, in dem die Auskoppeleffizienz in Abhängigkeit von der Dicke einer unteren Begrenzungsschicht dargestellt ist;
- Figur 11: ein Diagramm, das die Abhängigkeit der Auskoppeleffizienz vom Flankenwinkel der Seitenflächen einer Mesa mit dem im Figur 10b dargestellten Querschnittsprofil zeigt;
- Figur 12: ein weiteres Diagramm, in dem die Abhängigkeit der Auskoppeleffizienz vom Flankenwinkel einer Mesa mit dem Querschnittsprofil aus Figur 10b dargestellt ist;
- Figur 13: ein Diagramm, das die Abhängigkeit der Auskoppeleffizienz von der Breite der aktiven Dünnfilmschicht bei gleichbleibender Höhe veranschaulicht;
- Figur 14: ein Diagramm, das die Abhängigkeit der Auskopplungseffizienz von der Dicke einer die Mesa verbindenden Deckschicht für verschiedene Profile der Mesen zeigt;
- Figur 15: eine schematische Darstellung eines Querschnitts durch ein weiteres Ausführungsbeispiel eines Halbleiterchips
- Figur 16: eine schematische Darstellung eines Querschnitts eines weiteren Ausführungsbeispiels eines Halbleiterchips
- Figuren 17a bis 17e: eine schematische Darstellung des Ablaufs eines ersten Verfahrens zur Herstellung einer Mehrzahl von Halbleiterchips
- Figuren 18a bis 18e: eine schematische Darstellung des Ablaufs eines zweiten Verfahrens zur Herstellung einer Mehrzahl von Halbleiterchips
- Figuren 19a bis 19e: eine schematische Darstellung des Ablaufs eines dritten Verfahrens zur Herstellung einer Mehrzahl von Halbleiterchips
- Figur 20: ein Bild eines Halbleiterchips von oben;
- Figur 21: ein Bild einer Schrägansicht einer Oberfläche einer Dünnfilmschicht nach Erzeugung von Kavitäten; und
- Figur 22: ein vergrößerter Ausschnitt des Bildes von Figur 21.

Gleiche oder gleichwirkende Bestandteile der Ausführungsbeispiele sind in den Figuren jeweils mit denselben Bezugszeichen versehen.

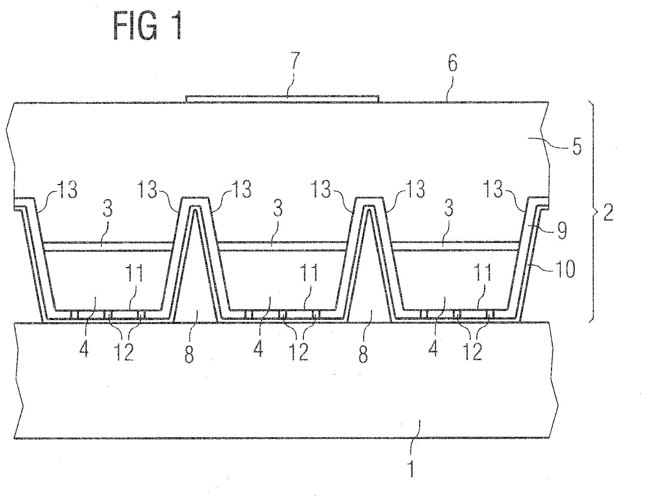

Der in Figur 1 dargestellte Halbleiterchip für eine Lumineszenzdiode weist ein Trägersubstrat 1 auf, auf dem die aktive Dünnfilmschicht 2 angebracht ist. Der Deutlichkeit halber ist in Figur 1 die Dicke der aktiven Dünnfilmschicht 2 im Verhältnis zu der Dicke des Trägersubstrats 1 übertrieben gezeichnet. Die aktive Dünnfilmschicht 2 weist eine Photonen emittierende, aktive Zone 3 auf, die jeweils auf einer mittleren Höhe in Mesen 4 ausgebildet ist. Die Mesen 4 können pyramidenstumpfartig oder kegelstumpfartig ausgebildet sein. Der Halbleiterchip stellt somit eine Lumineszenzdiode dar.
Die Mesen 4 sind an einer Deckschicht 5 angeordnet, die auf einer flachen Vorderseite 6 eine zentrale vorderseitige Kontaktstelle 7 aufweist, die vorzugsweise von einer Metallisierungsschicht gebildet ist. Die rückseitigen, von Kavitäten 8 gebildeten Mesen 4 sind mit einer Reflexionsschicht bedeckt, die aus einer dielektrischen Isolierschicht 9 und einer darauf aufgebrachten Metallisierungsschicht 10 besteht. Die Isolierschicht 9 ist entlang einer Grundfläche 11 der Mesen 4 durch Durchkontaktierungen 12 unterbrochen, die von metallisierten Abschnitten gebildet werden.

Die Isolierschicht 9 hat vorzugsweise einen kleineren Brechungsindex als die angrenzende Halbleiterschicht der Dünnfilmschicht 2. Sie ist weiterhin als Diffusionssperre für die Metallisierungsschicht 10 ausgebildet. An Stelle der Isolierschicht 9 kann auch eine elektrisch leitende Schicht verwendet sein. Maßgebend sind die optischen Eigenschaften dieser Schicht.

Zur Herstellung des in Figur 1 dargestellten Halbleiterchips wird zunächst auf einem Aufwachssubstrat die aktive Dünnfilmschicht 2 epitaktisch aufgewachsen. Die aktive Dünnfilmschicht 2 kann beispielsweise auf der Basis von InGaAlP hergestellt werden. Dabei wird zunächst die Deckschicht 5 auf dem Aufwachssubstrat ausgebildet und anschließend mit einer Konzentration oberhalb von 10¹⁸ cm⁻³ dotiert, um eine gute Leitfähigkeit der Deckschicht 5 zu gewährleisten. Denn eine gute Leitfähigkeit der Deckschicht 5 ist Voraussetzung dafür, dass auf der Vorderseite 6 des Lumineszenzdiodenchips eine zentrale Kontaktstelle 7 für die Versorgung der aktiven Zone 3 einer Mehrzahl von Mesen 4 mit Strom genügt. Außerdem ist die Zusammensetzung der Deckschicht 5 so gewählt, dass sie für die in der aktiven Zone erzeugten Photonen transparent ist. Dies lässt sich üblicherweise über eine Einstellung der Bandlücke durch die Zusammensetzung des Materials der Deckschicht 5 bewerkstelligen.

Anschließend wird eine weitere Schicht auf der Deckschicht 5 aufgebracht, in der die Mesen 4 mit geeigneten nass- oder trockenchemischen Ätzverfahren ausgebildet werden. Derartige Ätzverfahren sind bekannt und sind nicht Gegenstand der Anmeldung. Die Mesen 4 werden vorzugsweise nur in den für die Halbleiterchips vorgesehene Bereichen ausgebildet und dort bevorzugt wiederum nur in den Bereichen, in den Lichtauskopplung stattfinden kann, also nicht unter Kontaktschichten 7, 43 und 49 auf der Oberseite der Dünnfilmschicht 2. Die für die Halbleiterchips vorgesehenen Bereiche haben typische laterale Außenabmessungen von beispielsweise 400 x 400 µm². Die Mesen 4 weisen Außenabmessungen auf, die im Bereich der Schichtdicke der aktiven Dünnfilmschicht 2 liegen. Die Außenabmessungen der Mesen 4 liegen daher im Bereich von 10 µm.

In einem weiteren Verfahrensschritt erfolgt das Abscheiden der Isolierschicht 9 auf den Mesen 4 und das Ausbilden der Durchkontaktierungen 12. Danach wird die Metallisierungsschicht 10 aufgebracht.

Anschließend wird die aktive Dünnfilmschicht 2 entsprechend der vorgesehenen Zahl von Halbleiterchips aufgetrennt. Dies erfolgt beispielsweise durch Nassätzen.

Dann werden die vereinzelten aktiven Dünnfilmschichten 2 am Trägersubstrat 1 beispielsweise durch eutektisches Bonden befestigt und das Aufwachssubstrat durch Nassätzen entfernt. Abschließend werden die Kontaktstellen 7 auf der freigelegten Vorderseite der aktiven Dünnfilmschicht 2 ausgebildet und die Halbleiterchips durch Trennen des Trägersubstrats 1 vereinzelt.

Der in Figur 1 dargestellte Halbleiterchip weist den Vorteil auf, dass die von der aktiven Zone 3 erzeugten Photonen nicht auf Komponenten des Halbleiterchips treffen, die diese absorbieren. Denn durch die Metallisierungsschicht 10 werden die Photonen vom Trägersubstrat 1 ferngehalten. Das Trägersubstrat kann demzufolge vorteilhafterweise sehr gut hinsichtlich elektrischer und/oder thermischer Leitfähigkeit und/oder thermischer Ausdehnung optimiert werden.

Ein weiterer Vorteil ist, dass bei dem Halbleiterchip aus Figur 1 ein Großteil der von der aktiven Zone 3 emittierten Photonen an Seitenflächen 13 der Mesen 4 totalreflektiert wird. Die an den Seitenflächen 13 totalreflektierten Photonen treffen auf die Vorderseite 6 unter einem großen Winkel. Insbesondere trifft ein Teil der Photonen, der ohne Reflexion an den Seitenflächen 13 an der Vorderseite totalreflektiert würde, auf die Vorderseite 6 innerhalb des Austrittskegels und kann daher den Halbleiterchip verlassen. Bei dem Halbleiterchip gemäß Figur 1 wird daher die Reflexion an der aus dem Stand der Technik bekannten durchgehenden Grundfläche zumindest teilweise durch die Totalreflexion an den Seitenflächen 13 ersetzt. Daher weist der Halbleiterchip aus Figur 1 im Vergleich zu herkömmlichen Halbleiterchips ohne Kavitäten 8 eine nahezu um den Faktor 2 gesteigerte Lichtausbeute auf.

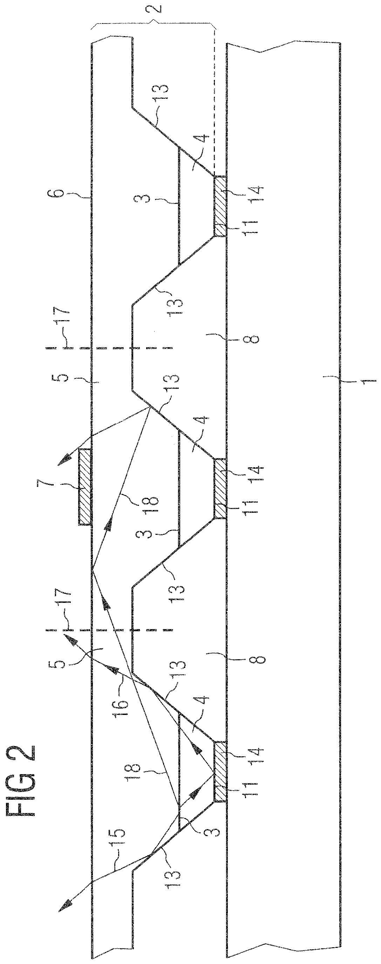

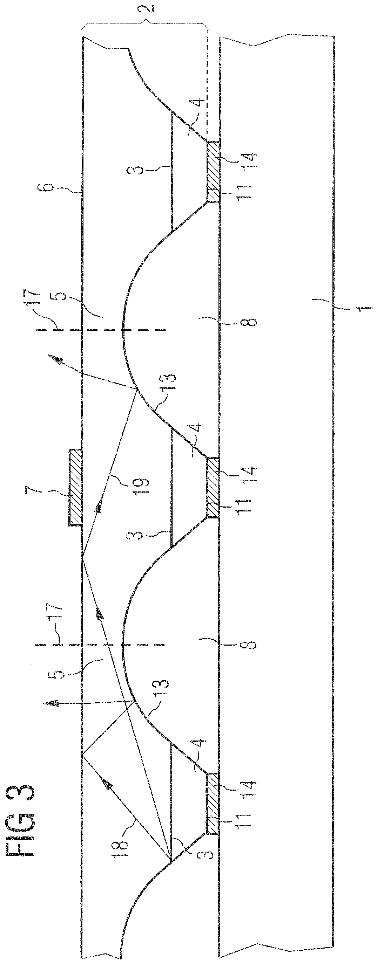

Der beschriebene Effekt sei im Folgenden anhand der in der Figur 2 und 3 dargestellten weiteren Ausführungsbeispiele im Einzelnen erläutert.

Betrachtet seien eine Reihe von Lichtstrahlen, wobei der Begriff Lichtstrahlen nicht als eine Einschränkung auf eine bestimmte Wellenlänge, sondern als Bezugnahme auf die Methoden der geometrischen Optik, unabhängig von der Wellenlänge, verstanden werden soll.

Bei dem in Figur 2 gezeigten Ausführungsbeispiel sind die Mesen 4 pyramidenstumpfförmig ausgebildet und lediglich an der Grundfläche 11 der Mesen 4 über eine Kontaktschicht 14 am Trägersubstrat 1 befestigt. Durch die Kontaktschicht 14 wird die aktive Zone 3 mit Strom versorgt.

Aufgrund der großen Differenz zwischen den Brechungsindizes von Halbleitern zu Gießharz von typischerweise 3,5 zu Werten von typischerweise 1,5 können an der Grenzfläche zwischen Halbleiter und Gießharz nur Lichtstrahlen aus dem Halbleiter auskoppeln, die innerhalb eines Austrittskegels mit einem Öffnungswinkel von etwa 16° auf die Grenzfläche auftreffen. Bei einem winkelmäßig gleich verteilten Einfall der Lichtstrahlen entspricht dies etwa 2% der auf eine Flächeneinheit einfallenden Lichtstrahlen.

Durch die Mesen 4 werden die von der aktiven Zone 3 ausgehende Lichtstrahlen in Richtung auf die Vorderseite 6 gelenkt. Die Mesen 4 bewirken, dass die auf die Seitenflächen 13 auftreffenden Lichtstrahlen in Richtung auf die Vorderseite 6 umgelenkt werden und dort innerhalb des Austrittskegels auftreffen, so dass sie den Halbleiterchip verlassen können. Die Lichtausbeute kann dabei durch eine geeignete Wahl der Abmessungen der Grundfläche 11, des Neigungswinkels der Seitenfläche 13 und der Höhe der Mesen 4 sowie die Lage der aktiven Zone 3 optimiert werden.

In Figur 2 ist ein Lichtstrahl 15 gezeigt, der zunächst an der Seitenfläche 13 totalreflektiert und von dort zur Vorderseite 6 gelenkt wird. Auf der Vorderseite 6 trifft der Lichtstrahl 15 innerhalb des Austrittskegels auf die Grenzfläche auf und kann daher den Halbleiterchip verlassen. Ohne die Totalreflexion an der Seitenfläche 13 wäre der Lichtstrahl 15 an der Vorderseite 6 totalreflektiert und zu einer der aus dem Stand der Technik bekannten Reflexionsschichten zurückgelenkt worden, wo er erneut reflektiert worden wäre. Insofern wird bei dem in Figur 2 dargestellten Ausführungsbeispiel die Reflexion an der herkömmlichen durchgehenden Reflexionsschicht durch die Reflexion an den Seitenflächen 13 ersetzt.

Dies gilt auch für einen Lichtstrahl 16, der zunächst an der Grundfläche 11 und dann an der Seitenfläche 13 reflektiert wird. Auch der Lichtstrahl 16 wird nach der zweiten Reflexion zu der Vorderseite 6 gelenkt, wo er innerhalb des Austrittskegels auftrifft. Ohne die Reflexion an der Seitenfläche 13 wäre der Lichtstrahl 16 ebenfalls an der Vorderseite 6 totalreflektiert und zu einer rückseitigen Reflexionsschicht zurückgelenkt worden.

Von Vorteil ist ferner, dass die Mesen 4 über die Deckschicht 5 optisch gekoppelt sind. Unter der optischen Kopplung soll in diesem Zusammenhang verstanden werden, dass wenigstens einer der von der aktiven Dünnfilmschicht 2 ausgehenden Lichtstrahlen über eine Mittellinie 17 hinweg von dem Bereich einer der Mesen 4 in den Bereich einer der benachbarten Mesen 4 gelangen kann. Denn durch die optische Kopplung mit Hilfe der Deckschicht 5 kann ein Lichtstrahl 18, der nicht auf eine der Seitenflächen 13 der jeweiligen Mesen 4 trifft, auf eine der Seitenflächen 13 einer der benachbarten Mesen 4 treffen und dort zur Vorderseite 6 gelenkt werden, wo er innerhalb des Austrittskegels auftrifft. Durch die optische Kopplung über die Deckschicht 5 wird daher die Lichtausbeute weiter gesteigert.

In Figur 3 ist schließlich ein Querschnitt durch ein abgewandeltes Ausführungsbeispiel des Halbleiterchips dargestellt, bei dem die Mesen 4 kegelstumpfförmig mit konkaven Seitenflächen 13 ausgebildet sind. Die Ausgestaltung der Seitenflächen 13 führt dazu, dass ein zwischen der Vorderseite 6 und der Seitenfläche 13 hin und her reflektierter Lichtstrahl 18 bei Annäherung an die Mittellinie 17 zunehmend zur Vorderseite hin umgelenkt wird, bis er innerhalb des Austrittskegels auf die Vorderseite 6 auftrifft. Das gleiche gilt für Lichtstrahlen 19, die zunächst über die Deckschicht 5 von jeweils einer Mesa 4 zur benachbarten Mesa 4 gelangen und dort in einem großen Winkel zur Vorderseite 6 gebracht werden.

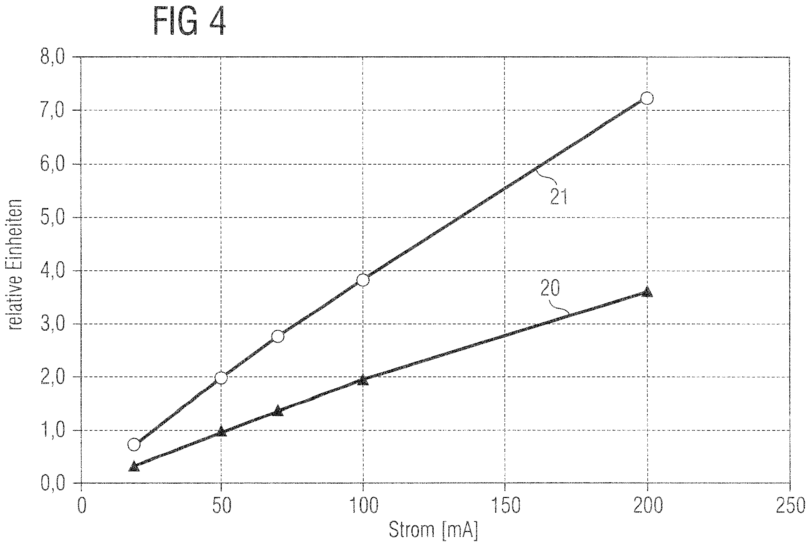

In Figur 4 ist schließlich ein Diagramm dargestellt, in dem eine Messkurve 20 die Abhängigkeit der Lichtausbeute in relativen Einheiten vom Betriebsstrom bei Pulsbetrieb für eine herkömmliche, in Dünnfilmtechnik hergestellte Leuchtdiode darstellt. Eine weitere Messkurve 21 veranschaulicht die Abhängigkeit der Lichtausbeute in relativen Einheiten in Abhängigkeit vom Betriebsstrom für eine Leuchtdiode gemäß dem in Figur 3 dargestellten Ausführungsbeispiel. Figur 4 ist zu entnehmen, dass die Lichtausbeute bei dem in Figur 3 dargestellten Ausführungsbeispielen etwa das Doppelte der Lichtausbeute von herkömmlichen Halbleiterchips ohne Kavitäten 8 aufweist.

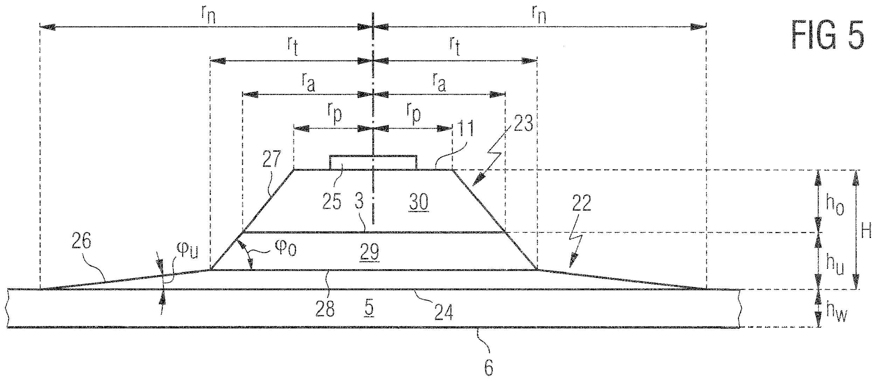

Um die günstigste Form für die Mesen 4 zu ermitteln, wurde eine Reihe von Untersuchungen durchgeführt. Die Ergebnisse dieser Untersuchungen werden nachfolgend anhand der Figuren 5 bis 14 im Einzelnen vorgestellt.

Zunächst seien die in den Untersuchungen variierten Parameter anhand Figur 5 erläutert. In Figur 5 ist ein Querschnittsprofil einer der Mesen 4 dargestellt. In dem gezeigten Fall ist die Mesa 4 aus einem unteren Kegelstumpf 22 und einem oberen Kegelstumpf 23 zusammengesetzt. Der untere Kegelstumpf 22 grenzt mit einer Basisfläche 24 an die Deckschicht 5 an. Im oberen Kegelstumpf 23 ist die aktive Zone 3 ausgebildet. Außerdem ist in Figur 5 eine auf der Grundfläche 11 der Mesa 3 angeordnete Kontaktstelle 25 vorgesehen.

Die Seitenflächen 13 der Mesa 4 setzen sich aus einer Flanke 26 des unteren Kegelstumpfs 22 und Flanken 27 des oberen Kegelstumpfs 23 zusammen. Die geometrischen Abmessungen des unteren Kegelstumpfes 22 entlang einer gemeinsamen Grenzfläche 28 sind so gewählt, dass die Flanke 26 unmittelbar in die Flanke 27 übergeht.

Im Folgenden wird auf verschiedene Abmessungen der Mesa 4 Bezug genommen. Der Radius der Basisfläche 24 des unteren Kegelstumpfes 22 wird mit rₙ, der Radius der Grenzfläche 28 mit rₜ und der Radius der Grundfläche 11 mit rₚ bezeichnet. Ferner kann die Mesa 4 in eine untere Begrenzungsschicht 29 zwischen der Basisfläche 24 und der aktiven Zone 3 und eine obere Begrenzungsschicht 30 zwischen der aktiven Zone 3 und der Grundfläche 11 unterteilt werden. Die untere Begrenzungsschicht 29 weist dabei eine Höhe hᵤ und die obere Begrenzungsschicht 30 eine Höhe hₒ auf. Die gesamte Höhe der Mesa 4 wird schließlich mit H bezeichnet. Sie wurde durchgehend in allen Untersuchungen gleich 6 µm gesetzt. Für die Dicke h_{w} der Deckschicht 5 wurde in allen Untersuchungen, in denen die Dicke h_{w} nicht variiert wurde, ein Wert von 2 µm gewählt.

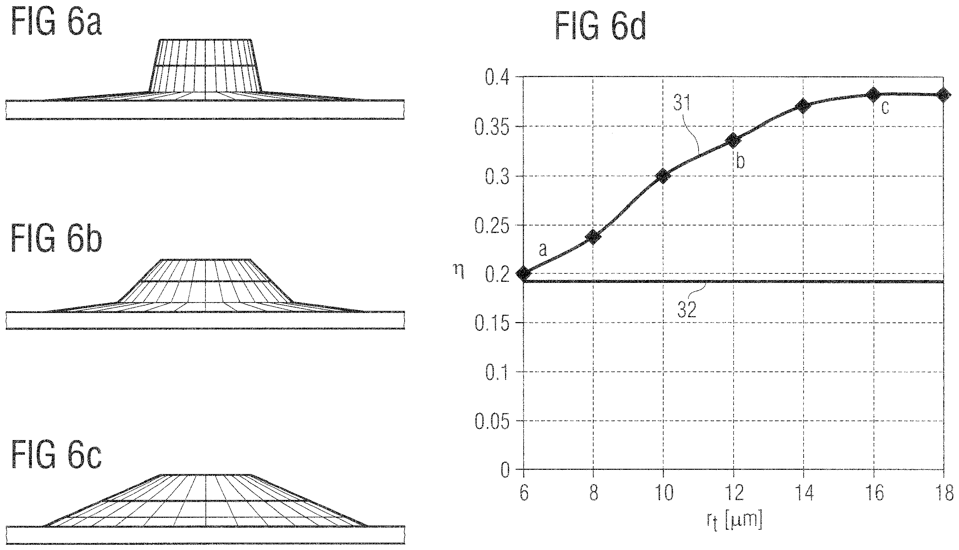

In den Figuren 6a bis 6d ist das Ergebnis einer Rechnung dargestellt, in der der Radius rₚ der Grundfläche 11 gleich 5 µm und der Radius rₙ der Basisfläche 24 gleich 20 µm gesetzt wurde. Der Radius rₜ der Grenzfläche 28 wurde zwischen 6 und 18 µm entsprechend den in Figur 6a bis Figur 6c dargestellten Querschnittsprofilen variiert.

In den Untersuchungen wurde für die aktive Zone 3 ein Brechungsindex von 3,2 verwendet. Der Brechungsindex der unteren Begrenzungsschicht 29, der oberen Begrenzungsschicht 30 sowie der Deckschicht 5 war gleich 3,3. Soweit nicht variiert, wurde die Reflektivität der Kontaktstelle 25 mit 0,3 verwendet. Die Reflektivität der von der Kontaktstelle 25 nicht bedeckten Grundfläche 11 sowie der Flanken 26 und 27 wurde auf den Wert 0,8 gesetzt. Unter Reflektivität wird dabei jeweils der auf die Energie bezogene Reflexionskoeffizient verstanden.

Ferner wurde die Selbstabsorption der aktiven Zone 3 durch einen Absorptionskoeffizient von 10.000/cm berücksichtigt. Alle Untersuchungen wurden mit Photonenrecycling durchgeführt. Dafür wurde eine interne Quanteneffizienz von 0,8 angenommen. Die Quanteneffizienz bei der Erzeugung von Photonen durch Ladungsträgerrekombination wurde nicht berücksichtigt. Die in den Diagrammen angegebene Auskoppeleffizienz *η* ist daher gleich dem Verhältnis der aus dem Halbleiterchip ausgekoppelten Photonen zur Zahl der tatsächlich erzeugten Photonen. Die Werte für die angegebene Auskoppeleffizienz *η* müsste daher noch mit dem Faktor 0,8 multipliziert werden, um zum externen Wirkungsgrad zu kommen.

Weiter wurde angenommen, dass die Reflexion an der Kontaktstelle 25 und den Flanken 26 und 27 winkelunabhängig ist. In den Untersuchungen wird daher der Fall, dass zunächst die dielektrische Isolierschicht 9 auf die Mesen 4 aufgebracht und durch die spiegelnde Metallisierungsschicht 10 ergänzt wird, in den Untersuchungen in seiner Wirkung unterschätzt, da in den Untersuchungen die in diesem Fall auftretende Totalreflexion nicht berücksichtigt wird.

Figur 6c zeigt ein Diagramm, in dem die Auskoppeleffizienz *η* gegen den Radius rₜ in einer Kurve 31 aufgetragen ist. Zum Vergleich ist auch die Auskoppeleffizienz eines normalen Dünnfilm-Halbleiterchips eingezeichnet, bei dem die Streuung nur über das Photonenrecycling vermittelt wird. Dieser Dünnfilm-Halbleiterchip mit der Kantenlänge 300 µm weist die gleiche Epitaxiestruktur wie die Mesa 4 im unteren Kegelstumpf 22 und oberen Kegelstumpf 23 auf. Es wurde angenommen, dass der Halbleiterchip p-seitig mit einem Spiegel versehen ist, dessen Reflektivität 0,72 beträgt. Dieser Wert ist der mit dem Belegungsgrad gewichtete Mittelwert der Reflektivität einer Reflexionsschicht und einer Kontaktschicht, wobei für die Reflektivität der Reflexionsschicht der Wert 0,8 und für den Belegungsgrad der Reflexionsschicht der Wert 0,85 verwendet und für die Reflektivität der Kontaktschicht der Wert 0,3 und der Belegungsgrad 0,15 verwendet wurde.

Aus Figur 6 ist erkennbar, dass bei einem sehr großen Anstellwinkel ϕₒ des oberen Kegelstumpfs 23 gemäß dem in Figur 6a dargestellten Querschnittsprofil die Auskoppeleffizienz *η* kaum besser als die Auskoppeleffizienz *η* einer herkömmlichen Dünnfilm-Lumineszenzdiode ist, deren Auskoppeleffizienz in Figur 6d durch die Gerade 32 dargestellt ist. Dies ist auch verständlich, da die Mesa 4 mit dem in Figur 6a dargestellten flachen Flächenquerschnittsprofil kaum die von der aktiven Zone 3 ausgehenden Lichtstrahlen in einen steilen Winkel zur Leuchtfläche 6 bringt. Genau dies bewerkstelligt jedoch die Mesa 4 mit dem in Figur 6c dargestellten Querschnittsprofil, weshalb auch in diesem Fall die Auskoppeleffizienz *η* nahezu das Doppelte der Auskoppeleffizienz *η* einer herkömmlichen Dünnschicht-Lumineszenzdiode beträgt.

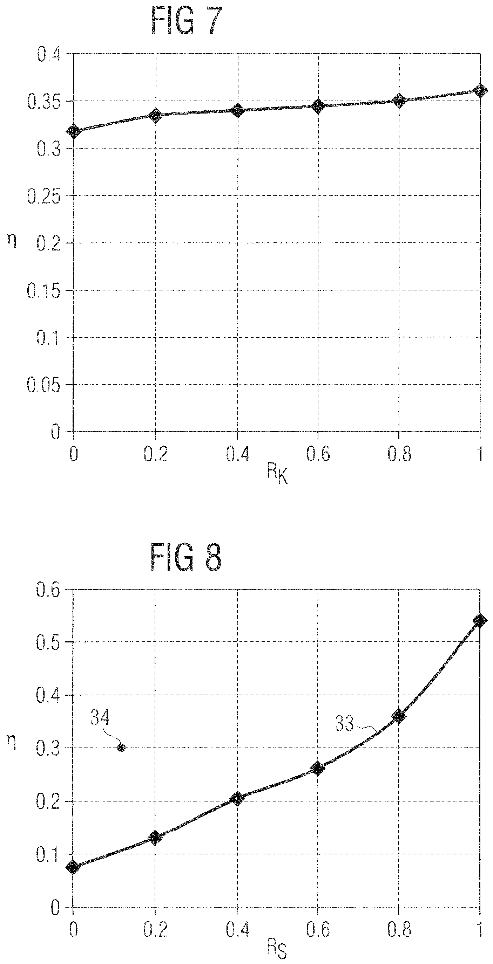

Des Weiteren wurde die Abhängigkeit der Auskoppeleffizienz *η* von der Reflektivität der Kontaktstelle 25 untersucht. Zu diesem Zweck wurde die Auskoppeleffizienz *η* in Abhängigkeit von der Reflektivität der Kontaktstelle 25 berechnet, wobei das Querschnittsprofil der Mesa 4 gleich dem in Figur 6b dargestellten Querschnittsprofil war. Außerdem wurde angenommen, dass die Kontaktstelle 25 die gesamte Grundfläche 11 abdeckt. Aus Figur 7 ist erkennbar, dass die Auskoppeleffizienz *η* nicht wesentlich von der Reflektivität der Kontaktstelle 25 abhängt. Die hier beschriebenen Halbleiterchips mit Mesen 4 auf der Befestigungsseite erscheinen daher wesentlich unempfindlicher gegen die schlechte Reflektivität der Kontaktstellen 25 zu sein als die herkömmliche Dünnfilm-Lumineszenzdioden, da die zur Auskopplung führenden Vielfachreflexionen offenbar nur zu einem geringen Bruchteil zwischen der Grundfläche 11 und der Leuchtfläche 6, sondern dreidimensional in der Mesa 4 erfolgen.

Die relative Unabhängigkeit von der Reflektivität der Kontaktstelle 25 ist besonders von Vorteil, da in der Praxis ein niedriger ohmscher Widerstand zwischen der Kontaktstelle 25 und der oberen Begrenzungsschicht 30 im Allgemeinen mit einer schlechten Reflektivität verknüpft ist. Denn ein guter ohmscher Kontakt erfordert die Diffusion von Atomen aus der die Kontaktstelle 25 bildenden Schicht in das darunter liegende Material.

Im Gegensatz zur Abhängigkeit von der Reflektivität der Kontaktstelle 25 ist die Abhängigkeit der Auskoppeleffizienz *η* von der Reflektivität R_{S} der Spiegelflächen auf der Grundfläche 11 und den Flanken 26 und 27 stark ausgeprägt. Dies zeigen die Ergebnisse einer Rechnung, die mit einem Modell für den Halbleiterchip durchgeführt worden sind, dessen Mesen 4 die Radien rₚ = 5 µm, r_{d} = 16 µm und rₙ = 20 µm aufweisen.

Die Mesen 4 weisen daher in etwa das in Figur 6b dargestellte Querschnittsprofil auf.

Das Ergebnis dieser Rechnung ist eine in Figur 8 eingetragene Kurve 33, die monoton mit zunehmender Reflektivität R_{S} ansteigt. Ein in das Diagramm aus Figur 8 eingetragener Punkt 34 stellt das Ergebnis einer Rechnung für einen Halbleiterchip dar, auf den keine Spiegelschicht aufgebracht wurde, sondern der in Harz als umgebendes Medium eingebettet wurde. Hier findet allerdings Totalreflexion statt, so dass sich gegenüber einem Halbleiterchip mit einer Spiegelschicht eine größere Auskoppeleffizienz ergibt. Dies wäre auch bei dem in Figur 1 dargestellten Ausführungsbeispiel der Fall, bei dem zwischen der Metallisierungsschicht 10 die elektrische Isolierschicht angeordnet ist, an der gleichfalls Totalreflexion stattfinden kann.

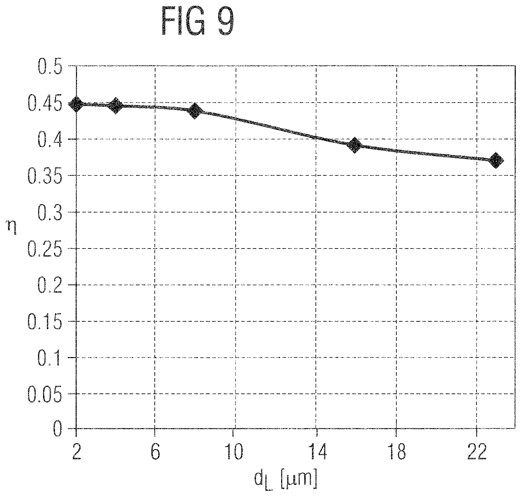

Figur 9 enthält das Ergebnis einer Rechnung, die an einem Halbleiterchip mit Mesen 4 ausgeführt wurde, für deren Radien galt: rₚ = 5 µm, rₜ = 16 µm und rₙ = 20 µm. Die Mesen 4 weisen daher im Wesentlichen das die Figur 6b dargestellte Querschnittsprofil auf. Die aktive Zone 3 befand sich dabei auf mittlerer Höhe zwischen der Basisfläche 24 und der Grundfläche 11. Bei dieser Rechnung wurde der Bereich, in dem in der aktiven Zone 3 Photonen entstehen auf einen Leuchtfleck eingeengt, dessen Durchmesser d_{L} auf der Abszisse aufgetragen ist. Anhand des Diagramms in Figur 9 ist erkennbar, dass die Auskoppeleffizienz bei einem kleinen Leuchtfleck besonders hoch ist. Das bedeutet, dass Photonen im Zentrum der aktiven Zone 3 besonders gut ausgekoppelt werden. Insofern ist ein leichter Weierstrass-Effekt vorhanden.

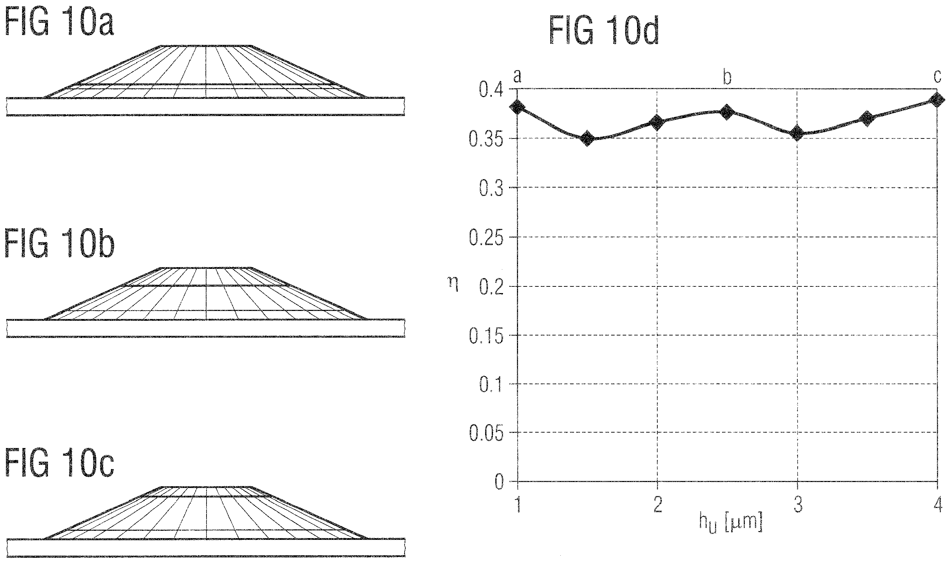

Ferner wurde der Einfluss der Position der aktiven Zone 3 untersucht. In Figuren 10a bis 10c sind verschiedene Querschnittsprofile dargestellt, bei denen die Dicke hᵤ der unteren Begrenzungsschicht 29 und die Dicke hᵤ der oberen Begrenzungsschicht 30 so variiert wurden, dass die gesamte Höhe H der Mesa konstant blieb. Das Ergebnis der Rechnung ist in Figur 10d dargestellt, in der die Auskoppeleffizienz *η* in Abhängigkeit von der Dicke hᵤ der unteren Begrenzungsschicht 29 aufgetragen ist. Es zeigt sich, dass die Auskoppeleffizienz *η* nur wenig von der Position der aktiven Zone 3 abhängig ist. Eine aktive Zone 3, die in der unteren Hälfte der Mesa 4 liegt, ist zu bevorzugen, da dann die Stromdichte durch die aktive Zone 3 gering ist und daher die Strombelastung der aktiven Zone 3 klein gehalten wird, was Alterungs- und Linearitätsprobleme vermeidet.

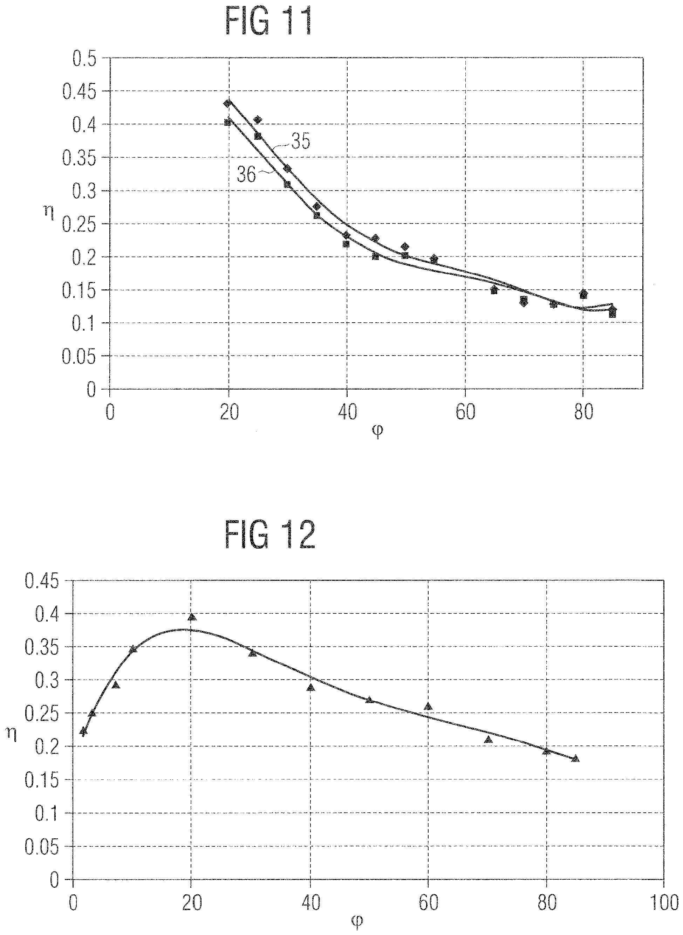

Weiter wurde der Einfluss des Anstellwinkel ϕₒ der Flanke 27 und des Anstellwinkels ϕᵤ der Flanke 26 untersucht. Dabei wurde von einem Querschnittsprofil ausgegangen, bei dem der untere Kegelstumpf 22 und der obere Kegelstumpf 23 jeweils den gleichen Wert für die Anstellwinkel ϕᵤ und ϕₒ aufweisen. Dabei wurde der Radius ϕₒ der aktiven Zone 3 konstant auf 10 µm gehalten und der Anstellwinkel ϕ = ϕₒ = ϕᵤ variiert. Dabei wurden zwei Fälle betrachtet. Zum einen wurde die Auskoppeleffizienz *η* für den Fall periodischer Randbedingungen untersucht, wobei der Abstand der Fußpunkt 10 µm beträgt. Das Ergebnis ist im Diagramm in Figur 11 in der Kurve 35 festgehalten. Außerdem wurde ein aperiodischer Fall untersucht. Dazu wurde die Auskoppeleffizienz *η* eines Halbleiterchips mit einer einzelnen Mesa 4 berechnet, wobei alle in die Deckschicht 5 einlaufenden Phontonen von der Deckschicht 5 absorbiert werden. Der aperiodische Fall wird in Figur 11 durch die Kurve 36 wiedergegeben. Aus Figur 11 ist bereits erkennbar, dass die Deckschicht 5 einen spürbaren Beitrag zur Auskoppeleffizienz *η* liefert.

Für den Flankenwinkel ϕ existiert auch ein optimaler Bereich. Dies wird anhand Figur 12 deutlich. In der zugrunde liegenden Rechnung wurde der Radius rₚ gleich 10 µm gesetzt. Der Radius rₐ der aktiven Zone 3 und der Radius rₙ der Basisfläche 24 wurden so variiert, dass der Anstellwinkel ϕ der Flanken 27 und 26 einen Wertebereich zwischen 1,5° und 85° abdeckt. Wie aus Figur 12 erkennbar ist, gibt es einen optimalen Winkelbereich für den Anstellwinkel ϕ. Der Flankenwinkel ϕ sollte zwischen 5° und 60°, vorzugsweise zwischen 10° und 40° liegen. Besonders gute Werte für die Auskoppeleffizienz *η* ergeben sich wenn der Anstellwinkel ϕ zwischen 15° und 30° liegt.

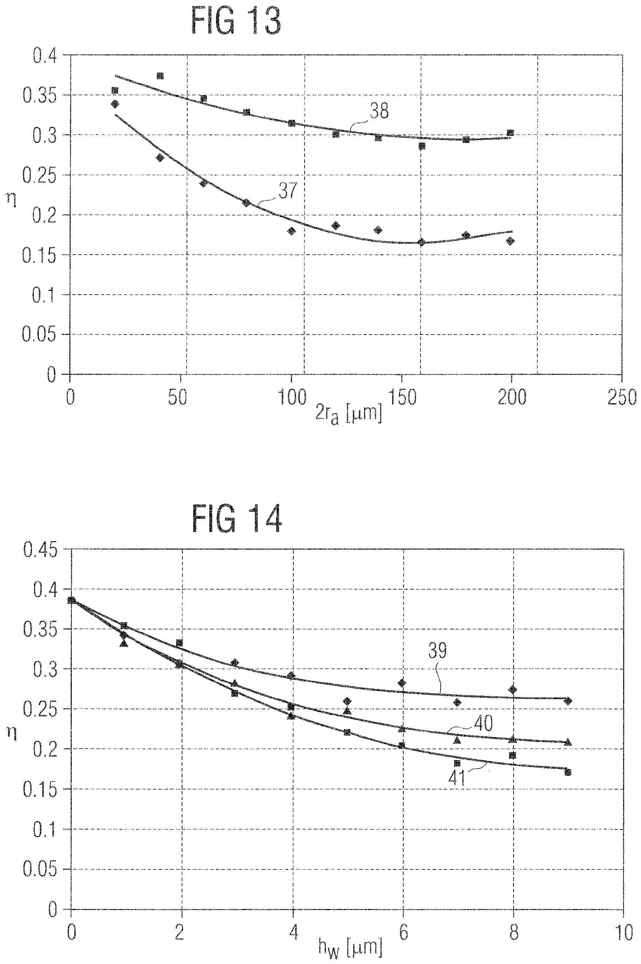

Anschließend wurde untersucht, welche Auswirkung eine Variation der Breite der Mesen 4 auf die Auskoppeleffizienz *η* hat. In diesem Fall wurde daher die Höhe H der Mesen 4 konstant gehalten und die Radien rₚ, rₐ und rₙ gleichmäßig gestreckt. Eine Kurve 37 in Figur 13 veranschaulicht den Fall, dass die Reflektivität R_{K} der Kontaktstelle 25 gleich 0,3 ist. Eine weitere Kurve 38 betrifft den Fall, dass die Reflektivität R_{K} der Kontaktstelle 25 0,8 beträgt. Sowohl die Kurve 37 als auch die Kurve 38 zeigen die Abhängigkeit der Auskoppeleffizienz *η* vom Durchmesser 2rₐ der aktiven Zone 3. Bei guter Reflektivität der Kontaktstelle 25 sinkt die Auskoppeleffizienz *η* nur wenig mit zunehmendem Durchmesser der aktiven Zone 3. Die Kurve 37, die den realistischen Fall einer schlechten Reflektivität R_{K} der Kontaktstelle 25 veranschaulicht, zeigt jedoch, dass die Auskoppeleffizienz *η* mit zunehmendem Durchmesser der aktiven Zone 3 stark abnimmt. Die Auskoppeleffizienz *η* ist daher umso besser, je kleiner die seitliche Ausdehnung der Mesen 4 ist.

Auch die Dicke der Deckschicht 5 ist für die Auskoppeleffizienz *η* von Bedeutung. In Figur 14 ist die Auskoppeleffizienz *η* für verschiedene Fälle in Abhängigkeit von der Dicke h_{w} der Deckschicht 5 aufgetragen. Eine Kurve 39 gibt den bereits erwähnten periodischen Fall wieder. Eine weitere Kurve 40 betrifft den aperiodischen Fall und eine dritte Kurve 41 einen Fall, in dem quadratische Halbleiterchips mit einer Kantenlänge von 300 µm durch eine Verbindungsschicht untereinander verbunden sind. Man erkennt aus Figur 14, dass die Deckschicht 5 mit wachsender Schichtdicke zunehmend von Vorteil ist. Insbesondere ist es von Vorteil, wenn die Schichtdicke h_{w} kleiner als die Höhe der Mesen 4 ist, die im vorliegenden Fall 6 µm beträgt. Daraus folgt, dass die Tiefe der Kavitäten 8 größer als die Hälfte der Dicke der aktiven Dünnfilmschicht 2 sein sollte.

Allerdings geht aus Figur 14 auch hervor, dass eine Vielzahl von einzelnen Halbleiterchips, die jeweils eine Mesa 4 aufweisen, den besten Fall darstellen, da die Auskoppeleffizienz bei der Dicke h_{w} = 0 am höchsten ist. Einzelchips haben jedoch den Nachteil, dass ihre Leistung nicht beliebig vergrößert werden kann, da mit der Leistung auch die Abmessungen der Halbleiterchips skaliert werden müssen. Aus praktischen Gründen ist jedoch die Dicke von Epitaxieschichten begrenzt. Dies hat zur Folge, dass einzelne Halbleiterchips sich nicht für beliebig hohe Leistungen auslegen lassen. Die in den Figuren 1 bis 4 vorgestellten Halbleiterchips lassen sich jedoch nahezu beliebig skalieren, da nur die Zahl der Mesen 4 entsprechend der zunehmenden Fläche der Deckschicht 5 erhöht werden muss, um die Lichtleistung der Halbleiterchips zu steigern.
Eine weitere Untersuchung bezog sich auf die Frage, ob die aktive Zone 3 nicht auch in der Deckschicht 5 angeordnet sein kann. Dazu wurde die Auskoppeleffizienz für eine herkömmliche Dünnfilm-Lumineszenzdioden berechnet und diese gleich 1 gesetzt. Ein Halbleiterchip mit der aktiver Zone 3 in der Deckschicht 5 hat im Vergleich zur herkömmlichen Dünnfilm-Lumineszenzdiode eine Auskoppeleffizienz von 1,25. Für die in Figuren 1 bis 4 dargestellten Halbleiterchips ergab sich schließlich eine relative Auskoppeleffizienz von 1,67. Dies zeigt, dass auch dann eine Steigerung der Auskoppeleffizienz *η* erreichbar ist, wenn die aktive Zone 3 in der Deckschicht 5 angeordnet ist.

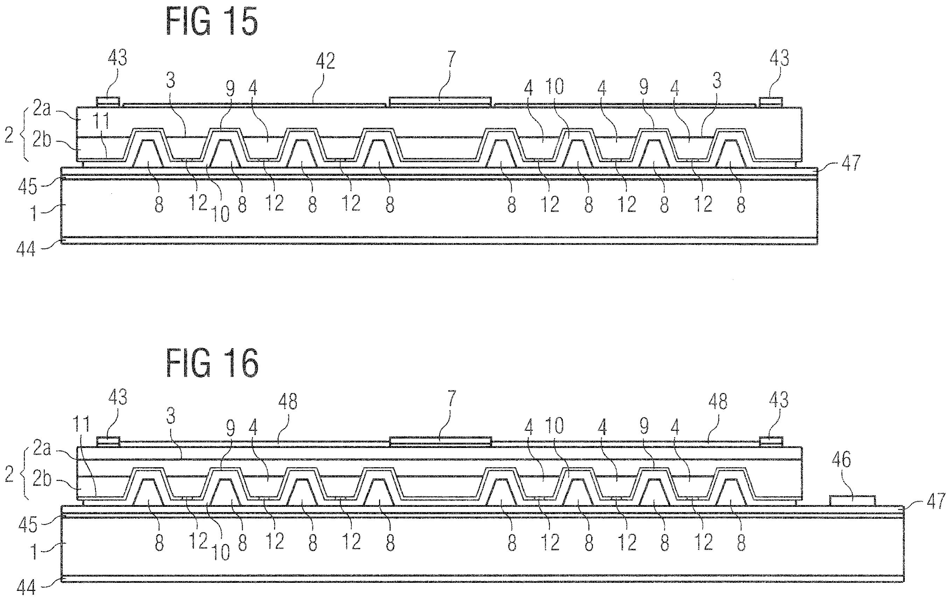

Figur 15 zeigt einen Dünnfilm-Lumineszenzdiodenchips in schematischer Darstellung. Die Dünnfilmschicht 2 besteht dabei aus einer mit Te hochdotierten n-InGaAlP-Schicht 2a (Konzentration > 10¹⁷ cm⁻³, bevorzugt > 10¹⁸ cm⁻³) mit einer Schichtdicke von etwa 4 µm und einer Mg-dotierten p-GaP-Schicht 2b mit einer Schichtdicke von etwa 3,5 µm.
Auf der zum Trägersubstrat 1 gewandten Befestigungsseite 11 der Dünnfilmschicht 2 sind, wie in Zusammenhang mit Fig. 1 beschrieben, eine Isolierschicht 9, beispielsweise aus Si₃N₄ und eine metallische Reflektorkontaktschicht 10 aufgebracht. Die Si₃N₄ - Schicht, die bezogen auf die Wellenlänge des von der aktiven Zone emittierten Lichts eine Dicke von vorzugsweise etwa drei Wellenlängen der emittierten Strahlung aufweist, führt neben ihrer elektrischen Isolationswirkung auch zu einer verbesserten Spiegelwirkung des metallischen Reflektors und stellt bei Verwendung eines geeigneten Materials gleichzeitig eine Diffusionssperre zwischen Dünnfilmschicht 2 und metallischer Reflektorschicht 10 dar.

Die Isolierschicht 9 kann alternativ ein Schichtstapel von beispielsweise abwechselnd Siliziumnitridschichten und Siliziumoxidschichten sein.

Die p-seitige Stromzuführung zu der aktiven Zone 3 wird durch einlegierte AuZn-Kontakte 12 gewährleistet, die an der dem Trägersubstrat 1 zugewandten Fläche der Mesen 4 angeordnet und durch die Isolierschicht 9 hindurchgeführt sind.

Die Reflektorkontaktschicht 10 ist vorzugsweise eine AuZn/TiW(N)/Au-Schicht. Sie kann aber auch vollständig aus Au, Al oder Ag oder aus einer Legierung aus diesen Metallen.

Um eine ausreichende mechanische Stabilität zu erreichen, ist die Dünnfilmschicht 2 durch Bonden auf das leitfähige Trägersubstrat 1, im Ausführungsbeispiel ein n-GaAs-Substrat, aufgebracht. Oberseite und Unterseite des Trägersubstrats 1 sind dabei beispielsweise mit AuGe-Kontaktschichten 44, 45 versehen. Auf der zur Dünnfilmschicht 2 gewandten Seite befindet sich auf der AuGe-Kontaktschicht 45 beispielsweise zusätzlich eine TiPtAu/AuSn-Schicht 47.

Auf der Vorder- oder Auskoppelseite des Chips ist ein Mittenkontakt 7 und ein Metallrahmen 43 oder ein anderer elektrisch leitender Rahmen vorgesehen, der über zwei nicht gezeigte elektrisch leitende Stege mit dem Mittenkontakt 7 verbunden ist. Der Mittenkontakt 7 und der Metallrahmen 43 bestehen beispielsweise aus einer TiPtAu-Schicht und einer zwischen dieser und der Dünnfilmschicht 2 angeordneten TiAuGe-Schicht.

Die hohe Leitfähigkeit der n-InGaAlP-Schicht gewährleistet die erforderliche Stromaufweitung. Die Stromzuführung zur p-Seite der aktiven Zone 3 erfolgt über die Kontaktschicht 44 an der Unterseite des Trägersubstrats 1 und durch dieses hindurch.

Zur weiteren Verbesserung der Lichtauskopplung ist auf der Vorderseite der Dünnfilmschicht 2 eine optische Vergütungsschicht 42 angeordnet, im Ausführungsbeispiel ein λ/4-Schicht aus Si₃N₄.
Wie bereits im Zusammenhang mit Fig. 2 beschrieben, sind in der Dünnfilmschicht 2 von der Verbindungsebene zwischen Trägersubstrat 1 und Dünnfilmschicht 2 her eine Mehrzahl pyramidestumpfförmiger Kavitäten 8 ausgebildet, die die Lichtauskopplung der Lumineszenzdiode deutlich erhöhen. Im Ausführungsbeispiel reichen die Kavitäten 8 so weit in die Dünnfilmschicht 2 hinein, dass sie den pn-Übergang 3 unterbrechen. Die Kavitäten 8 können aber auch nur so tief ausgebildet sein, dass sie den pn-Übergang nicht durchtrennen.
Neben der Steigerung der Lichtauskopplung haben die Kavitäten 8 zusätzlich den Vorteil, dass sie die beim eutektischen Bonden der Dünnfilmschicht 2 auf das Trägersubstrat 1 aufgrund der unterschiedlicher thermischen Ausdehnungskoeffizienten der verschiedenen Materialien auftretenden Spannungen erheblich abbauen. Somit wird die Prozeßsicherheit und die Fertigungsausbeute erhöht.
Ähnliches gilt für die Kompensation von während des Betriebes des Halbleiterchips auftretenden mechanischen Spannungen aufgrund unterschiedlicher thermischer Ausdehnungen bei Temperaturerhöhung durch Verlustleistung.

Figur 16 zeigt einen weiteren Halbleiterchip in schematischer Darstellung. In diesem Beispiel ist die Dünnfilmschicht 2 auf einem elektrisch isolierenden Trägersubstrat 1 aufgebracht, so dass die Stromzuführung zur p-Seite des pn-Übergangs 3 über einen neben der Dünnfilmschicht 2 auf der Au-Ge Kontaktschicht 45 angeordneten p-Kontakt 46 erfolgt.
Die p-InGaAlP Schicht 2b weist eine Dicke von 6 µm auf, die mit 1 x 10¹⁸ cm⁻³ dotierte n-InGaAlP:Te - Schicht 2a eine Dicke von 3 µm. Die Kavitäten 8 erstrecken sich bei dieser Aufführungsform in eine Tiefe von 5,5µm. Sie unterbrechen bei diesem Ausführungsbeispiel den pn-Übergang 3 also nicht.
Auf der vom Trägersubstrat 1 abgewandten Vorderseite der Dünnfilmschicht 2 ist in diesem Ausführungsbeispiel beispielhaft eine optische Vergütungsschicht 48 aus leitfähigem Indium-Zinn-Oxid angebracht, die neben der Verbesserung der Lichtauskopplung auch zur Stromaufweitung beiträgt. Die n-Schicht 2a kann hier folglich eventuell dünner ausgeführt sein, als bei Verwendung einer elektrisch isolierenden Vergütungsschicht, weil dann die Stromaufweitung nicht ausschließlich in der Dünnfilmschicht 2 erfolgen muss.
Eine solche elektrisch leitfähige Vergütungsschicht 48 kann auch bei allen anderen Halbleiterchips eingesetzt sein. Ebenso kann bei dem Beispiel von Figur 16 an Stelle der Indium-Zinn-OxidSchicht 48 eine isolierende Vergütungsschicht 42 eingesetzt sein.
Die in Figur 16 dargestellte Struktur eignet sich auch bei Verwendung eines leitfähigen Trägersubstrats 1 und ist nicht auf die Verwendung eines elektrisch isolierenden Trägersubstrats 1 beschränkt.

Die Struktur von Figur 16 hat den Vorteil, dass das Trägersubstrat 1 vorteilhafterweise insbesondere hinsichtlich thermischer Ausdehnung und/oder Wärmeleitfähigkeit optimiert werden kann, ohne auf dessen elektrische Leitfähigkeit achten zu müssen.

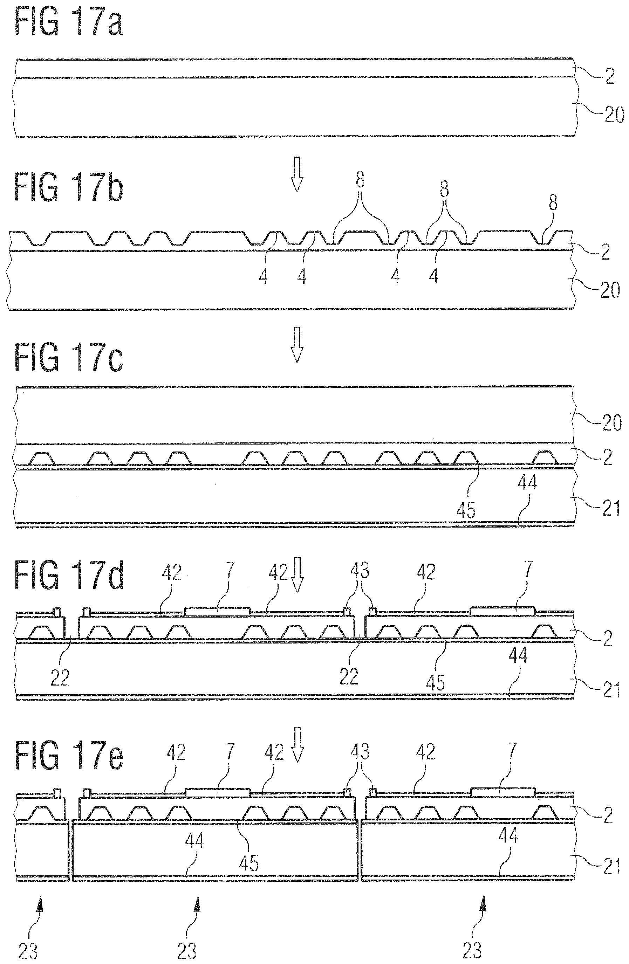

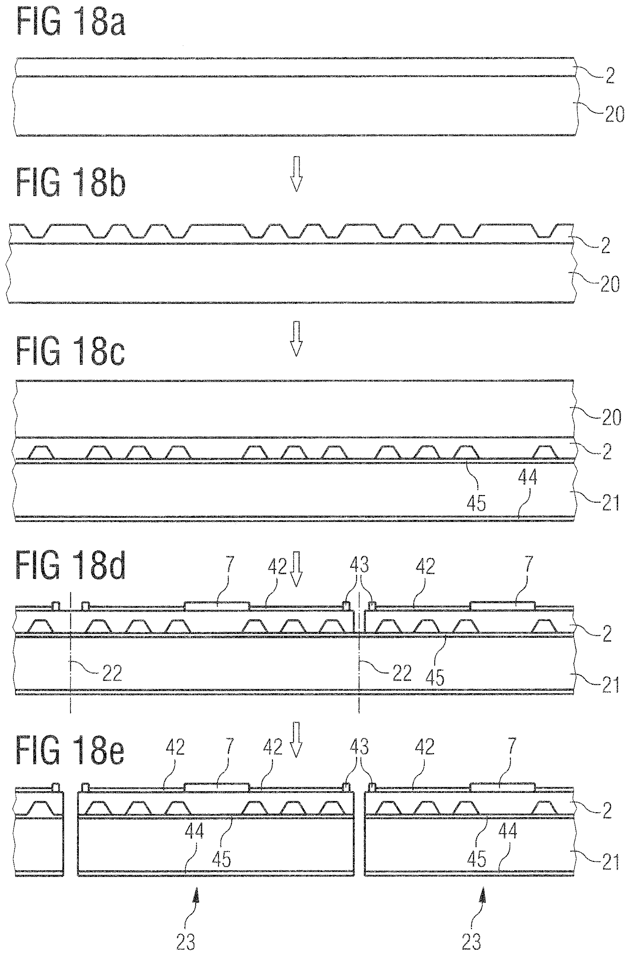

Bedarfsweise können zur Prozessierung der Dünnfilmschicht die Kavitäten 8 mit einem geeigneten Material verfüllt sein.
Der in den Figuren 17a bis 17e veranschaulichte Verfahrensablauf zum gleichzeitigen Herstellen einer Vielzahl von Halbleiterchips zeigt schematische Darstellungen senkrechter Schnitte durch einen Wafer zu verschiedenen Zeitpunkten des Herstellungsverfahrens. Auf eine detaillierte Darstellung insbesondere der aktiven Dünnfilmschicht 2 sowie der oben erläuterten Schichten zwischen dem Trägersubstrat und der Dünnfilmschicht mit all ihren Einzelheiten wurde hier und auch bei den Beschreibungen der Verfahren der Figuren 18a bis 19e der Einfachheit halber verzichtet.
Die Dünnfilmschicht 2, die Isolierschicht 9, die Kontaktschichten 7, 43 - 47 und 49 und die Vergütungsschicht 42, 48 werden beispielsweise mit herkömmlichen aus der Halbleitertechnik bekannten Abscheidungsverfahren hergestellt.
In einem ersten Teilprozess wird auf ein Aufwachssubstrat 20 eine aktive Dünnfilmschicht 2 aufgewachsen (Figur 17a). Wie weiter oben erläutert weist eine solche Dünnfilmschicht 2 in der Regel eine Mehrzahl von Halbleiterschichten verschiedener Zusammensetzungen auf.
Nachfolgend werden in der Dünnfilmschicht 2 zum Erzeugen der Mesen 4 in den Bereichen, in denen später die Lichterzeugung in den Halbleiterchips erfolgen soll, die Kavitäten 8 ausgebildet. Dies erfolgt beispielsweise durch eine geeignete Maskentechnik und anisotropem naßchemischen Ätzen (Figur 17b). Auf der mit den Kavitäten 8 versehenen Seite der Dünnfilmschicht 2 wird dann die Reflexionsschicht 9,10 (hier nicht gezeigt, siehe aber beispielsweise die Figuren 15 und 16) aufgebracht und werden an den Mesen 4 die Durchkontaktierungen 12 (hier nicht gezeigt, siehe aber beispielsweise die Figuren 15 und 16) hergestellt, bevor diese Seite nachfolgend mit einem Trägersubstratwafer 21 verbunden wird, auf dessen Hauptflächen sich vorzugsweise Kontaktschichten 44,45 befinden (Figur 17c).

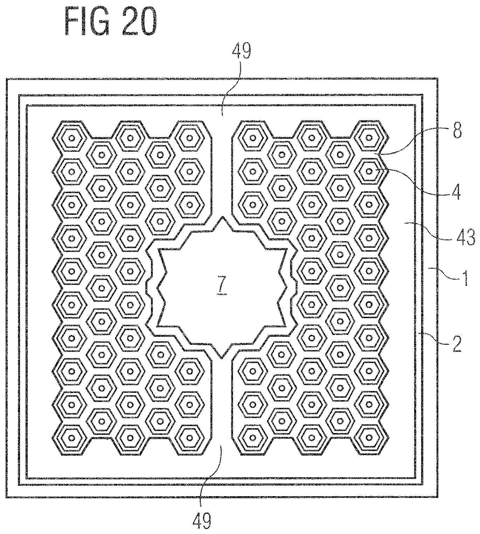

Nach zumindest teilweisem, vorzugsweise vollständigem Entfernen des Aufwachssubstrat 20 werden auf die freigelegte Fläche der Dünnfilmschicht 2 in jedem Flächenbereich, in dem ein Halbleiterchip entstehen soll, ein Bondpad 7 aufgebracht, mit dem über Anschlussstege 49 (siehe Figur 20) ein Stromzuführungsrahmen 43 verbunden ist, der am äußeren Rand der Dünnfilmschicht 2 des späteren Chips verläuft. Beispielhafte Materialien solcher Kontaktschichten sind oben bereits genannt. Die Strahlungsauskoppelflächen der späteren Chips, die sich zwischen den Bondpads 7 und den Kontaktierungsrahmen 70 befinden, werden mit einer optischen Vergütungsschicht 42 versehen. Man vergleiche hierzu Figur 17d.

Vor dem Vereinzeln des derart prozessierten Wafers wird die Dünnfilmschicht 2 entlang der Trennpfade 22 vorzugsweise mittels Ätzen durchtrennt und an den dadurch entstehenden Flanken der Dünnfilmschicht erforderlichenfalls eine Damageätzung durchgeführt. Die Flanken der Dünnfilmschicht 2 können, falls erforderlich, mit einer Vergütungsschicht und/oder Passivierungsschicht versehen werden.

Nach diesem Schritt wird dann der Trägersubstratwafer 21 beispielsweise mittels Sägen oder Ritzen und Brechen entlang der Trennpfade 22 durchtrennt, so dass einzelne Halbleiterchips 23 entstehen.

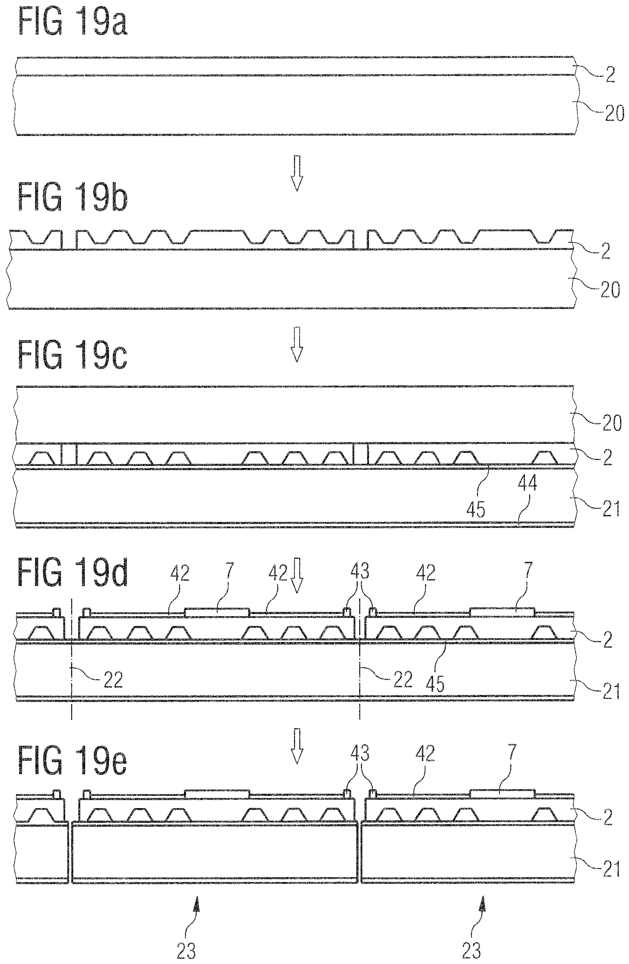

Die komplette Herstellung der Halbleiterchips erfolgt folglich vorteilhafterweise im Scheibenverbund; das heißt, dass die Vereinzelung des Wafers zu einzelnen Chips der letzte Schritt des Prozesses ist, bevor zu einem späteren Zeitpunkt die Chips beispielsweise in Gehäuse montiert werden.
Das in den Figuren 18a bis 18e dargestellte Verfahren unterscheidet sich von dem der Figuren 17a - 17e im Wesentlichen dadurch, dass das separate Durchtrennen der Dünnfilmschicht 2 vor dem Durchtrennen des Trägersubstratwafers 21 weggelassen wird und das Durchtrennen der Dünnfilmschicht 2 zusammen mit dem Durchtrennen des Trägersubstratwafers 21 entlang der Trennlinien 22 in einem Schritt erfolgt.
Das in den Figuren 19a bis 19e dargestellte Verfahren unterscheidet sich von dem der Figuren 17a - 17e im Wesentlichen dadurch, dass das separate Durchtrennen der Dünnfilmschicht 2 vor dem Verbinden der Dünnfilmschicht 2 mit dem Trägersubstratwafer 21 erfolgt.
Das Entfernen des Aufwachssubstrats kann anstatt mittels Schleifen und/oder nasschemischem Ätzen auch mittels Absprengen erfolgen. Hierzu wird vorzugsweise zwischen der Dünnfilmschicht und dem Aufwachssubstrat eine absorbierende Schicht eingebracht, die einen kleineren Bandabstand als das Aufwachssubstrat hat. Durch das Aufwachssubstrat hindurch wird die absorbierende Schicht mittels eines Lasers geeigneter Wellenlänge zerstört. Bei einem Aufwachssubstrat aus GaAs besteht die absorbierende Schicht beispielsweise aus InGaAs und der Laser ist beispielsweise ein IR-Laser.

Bei der in Figur 20 abgebildeten Ansicht eines Chips von oben sind die mittels Kavitäten 8 erzeugten Mesen 4 sichtbar. Zu sehen ist insbesondere, dass in den Bereichen des Kontaktes 7, der Verbindungsstege 49, des Stromzuführungsrahmens 43 und der Trennspuren keine Kavitäten 8 vorhanden sind. Dies sind alles Bereiche, in denen ohnehin keine oder nur wenig Strahlung ausgekoppelt werden würde. Das Weglassen der Kavitäten in diesen Bereichen führt vorteilhafterweise zu einer deutlichen mechanischen Stabilisierung der Dünnfilmschicht 2. Dies wirkt sich insbesondere im Bereich des Kontaktes 7 positiv aus, weil dort bei der Montage des Halbleiterchips in ein Gehäuse in der Regel ein Bonddraht aufgesetzt und aufgedrückt wird.

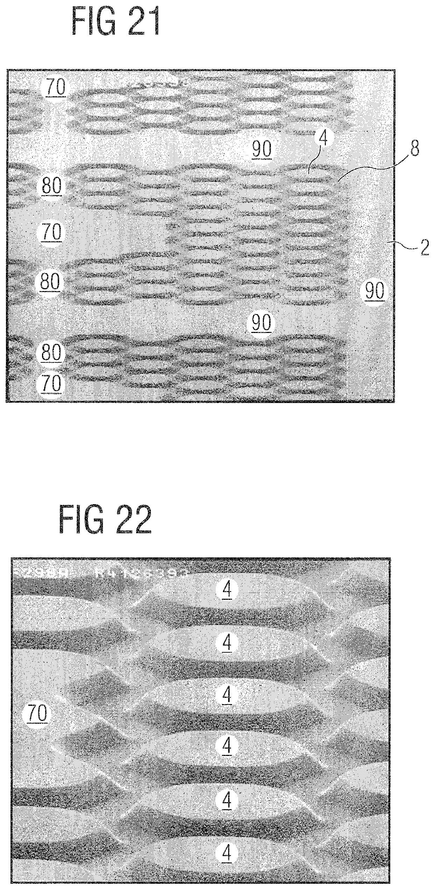

Die Figur 21 zeigt ein Bild einer Schrägansicht einer Oberfläche einer Dünnfilmschicht 2 nach Erzeugung der Kavitäten 8. Auch hier ist ersichtlich, dass in den Bereichen 70 der Kontakte 7, in den Bereichen 80 der Anschlussstege 49 und in den Bereichen 90 der Stromzuführungsrahmen 43 keine Mesen 4 vorhanden sind.
Figur 22 zeigt einen vergrößerten Ausschnitt von Figur 21.
Diese Anmeldung ist eine Teilanmeldung zur europäischen Patentanmeldung 019845056 .

## Patentansprüche

1. Halbleiterchip für die Optoelektronik, insbesondere strahlungsemittierender Halbleiterchip, mit
einer aktiven Dünnfilmschicht (2), in der eine Photonen emittierende Zone (3) ausgebildet ist; und
- einem Trägersubstrat (1) für die Dünnfilmschicht (2), das an einer von der Abstrahlrichtung des Chips abgewandten Seite der Dünnfilmschicht (2) angeordnet und mit dieser verbunden ist,
wobei
- in der aktiven Dünnfilmschicht (2) vom Trägersubstrat (1) her mindestens eine Kavität (8) ausgebildet ist, durch die an der Grenze zwischen Trägersubstrat (1) und Dünnfilmschicht (2) eine Mehrzahl von Mesen (4) ausgebildet ist, und
- die zumindest eine Kavität (8) derart tief ausgebildet ist, dass sie die aktive Zone (3) durchtrennt, **dadurch gekennzeichnet dass**,
- ein Aufwachssubstrat (20) von der aktiven Dünnfilmschicht (2) entfernt ist.

2. Halbleiterchip nach Anspruch 1,
wobei
- der Querschnitt der Kavität (8) im Verlauf vom Trägersubstrat (1) weg kleiner wird.

3. Halbleiterchip nach einem der vorhergehenden Ansprüche,
wobei
- durch eine Mehrzahl von Kavitäten (8) nur in denjenigen Bereichen, welche die strahlungserzeugenden Bereiche der Dünnfilmschicht (2) darstellen, Mesen (4) ausgebildet sind.

4. Halbleiterchip nach einem der vorhergehenden Ansprüche,
wobei
- wenigstens eine Trajektorie (18) der von der aktiven Zone (3) emittierten Photonen von der jeweiligen Mesa (4) zu einer der benachbarten Mesen (4) führt.

5. Halbleiterchip nach einem der vorhergehenden Ansprüche,
wobei
- sich die Mesen (4) zum Trägersubstrat hin verjüngen.

6. Halbleiterchip nach einem der vorhergehenden Ansprüche,
wobei
- die Mesen (4) konkave Seitenflächen (13) aufweisen.

7. Halbleiterchip nach einem der vorhergehenden Ansprüche,
wobei
- die Deckschicht (5) für die von der aktiven Zone (3) emittierten Photonen weitestgehend transparent ist.

8. Halbleiterchip nach einem der vorhergehenden Ansprüche,
wobei
- die Mesen (4) mit einer Reflexionsschicht (9, 10) bedeckt sind.

9. Halbleiterchip nach einem der vorhergehenden Ansprüche,
wobei
- die Reflexionsschicht eine mit einer Isolierschicht (9) unterlegte Metallisierungsschicht (10) aufweist.

10. Halbleiterchip nach einem der vorhergehenden Ansprüche,
wobei
- die aktive Dünnfilmschicht (2) eine Dicke von zwischen 5 µm und 25 µm aufweist.

11. Halbleiterchip nach einem der vorhergehenden Ansprüche,
wobei
- die Tiefe der zumindest einen Kavität (8) größer als die Hälfte der Dicke der Dünnfilmschicht (2) ist.

12. Halbleiterchip nach einem der vorhergehenden Ansprüche,
wobei
- die der Befestigungsseite (11) gegenüberliegende Oberfläche (6) der Dünnfilmschicht (2) mit einer optischen Vergütungsschicht (42) zur verbesserten Lichtauskopplung versehen ist, und
- die optische Vergütungsschicht (42) aus Siliziumnitrid oder aus leitfähigem Indium-Zinn-Oxid gebildet ist.

13. Halbleiterchip nach einem der vorhergehenden Ansprüche,
wobei
- die Dünnfilmschicht (2) im Bereich gegenüber einer oder mehrerer Kontaktstellen (7, 43) keine Kavität (8) aufweist.

14. Halbleiterchip nach einem der vorhergehenden Ansprüche,
wobei
- die Mesen (4) eine pyramidenstumpfartige oder kegelstumpfartige Form haben und die schrägen Seitenflächen einen Anstellwinkel ϕ gegen die laterale Erstreckungsrichtung der Dünnfilmschicht (2) von zwischen 5° und 60°, insbesondere zwischen 10° und 40°, insbesondere zwischen 15° und 30°, aufweisen.

15. Verfahren zum gleichzeitigen Herstellen einer Mehrzahl von Halbleiterchips für die Optoelektronik mit einer aktiven Dünnfilmschicht (2), in der eine Photonen emittierende aktive Zone (3) ausgebildet ist, mit den Verfahrensschritten:
- Epitaktisches Aufwachsen einer die Photonen emittierende Zone (3) enthaltende Schichtenfolge auf einem Aufwachssubstratwafer (20);
- Ausbilden von zumindest einer Kavität (8) in der Schichtenfolge, derart, dass eine Mehrzahl von Mesen (4) in der Schichtfolge entstehen;
- Aufbringen von zumindest einer Isolierschicht (9) auf die mit den Kavitäten (8) versehene Oberfläche der Schichtenfolge;
- Herstellen von jeweils mindestens einer Durchkontaktierung (12) auf den Mesen (4);
- Aufbringen des Scheibenverbundes aus Aufwachssubstratwafer (20) und Schichtenfolge auf einen Trägersubstratwafer (21) derart, dass die Mesen (4) zum Trägersubstratwafer (21) gewandt sind, und Verbinden des Scheibenverbundes mit dem Trägersubstratwafer (21) insbesondere mittels Löten oder Kleben;
- vollständiges Entfernen des Aufwachssubstratwafers (20);
- Aufbringen einer elektrischen Kontaktierung (7,43,49) auf die den Mesen (4) gegenüberliegenden Seite der Schichtenfolge; und
- Vereinzeln des Waferverbundes aus Trägersubstratwafer (21) und strukturierter Schichtenfolge entlang von Trennspuren (22) zu Halbleiterchips (23).

## Claims

1. Semiconductor chip for optoelectronics, in particular radiation-emitting semiconductor chip, comprising
an active thin-film layer (2), in which a photon-emitting zone (3) is formed; and
- a carrier substrate (1) for the thin-film layer (2), which carrier substrate is arranged on a side of the thin-film layer (2) facing away from the emission direction of the chip and is connected thereto,
wherein
- at least one cavity (8) is formed in the active thin-film layer (2) from the carrier substrate (1), by which a plurality of mesas (4) are formed at the boundary between the carrier substrate (1) and thin-film layer (2), and
- the at least one cavity (8) is formed with such a depth that it severs the active zone (3), **characterized in that**
- a growth substrate (20) is removed from the active thin-film layer (2).

2. Semiconductor chip according to Claim 1,
wherein
- the cross section of the cavity (8) becomes smaller in the course away from the carrier substrate (1).

3. Semiconductor chip according to either of the preceding claims,
wherein
- mesas (4) are formed by a plurality of cavities (8) only in those regions which constitute the radiation-generating regions of the thin-film layer (2).

4. Semiconductor chip according to any of the preceding claims,
wherein
- at least one trajectory (18) of the photons emitted by the active zone (3) leads from the respective mesa (4) to one of the adjacent mesas (4).

5. Semiconductor chip according to any of the preceding claims,
wherein
- the mesas (4) taper towards the carrier substrate.

6. Semiconductor chip according to any of the preceding claims,
wherein
- the mesas (4) have concave side surfaces (13).

7. Semiconductor chip according to any of the preceding claims,
wherein
- the cover layer (5) is transparent to the greatest possible extent to the photons emitted by the active zone (3).

8. Semiconductor chip according to any of the preceding claims,
wherein
- the mesas (4) are covered with a reflection layer (9, 10).

9. Semiconductor chip according to any of the preceding claims,
wherein
- the reflection layer comprises a metalization layer (10) with an insulating layer (9) situated underneath.

10. Semiconductor chip according to any of the preceding claims,
wherein
- the active thin-film layer (2) has a thickness of between 5 µm and 25 µm.

11. Semiconductor chip according to any of the preceding claims,
wherein
- the depth of the at least one cavity (8) is greater than half the thickness of the thin-film layer (2).

12. Semiconductor chip according to any of the preceding claims,
wherein
- the surface (6) of the thin-film layer (2) that is situated opposite the fixing side (11) is provided with an optical antireflection layer (42) for improved coupling-out of light, and
- the optical antireflection layer (42) is formed from silicon nitride or from conductive indium tin oxide.

13. Semiconductor chip according to any of the preceding claims,
wherein
- the thin-film layer (2) has no cavity (8) in the region opposite one or a plurality of contact locations (7, 43).

14. Semiconductor chip according to any of the preceding claims,
wherein
- the mesas (4) have a truncated-pyramid-like or truncated-cone-like shape and the oblique side surfaces have a setting angle ϕ relative to the lateral direction of extent of the thin-film layer (2) of between 5° and 60°, in particular between 10° and 40°, in particular between 15° and 30°.

15. Method for simultaneously producing a plurality of semiconductor chips for optoelectronics comprising an active thin-film layer (2), in which an active photon-emitting zone (3) is formed, comprising the following method steps:
- epitaxially growing a layer sequence containing the photon-emitting zone (3) on a growth substrate wafer (20);
- forming at least one cavity (8) in the layer sequence, in such a way that a plurality of mesas (4) arise in the layer sequence;
- applying at least one insulating layer (9) to that surface of the layer sequence which is provided with the cavities (8);
- producing in each case at least one plated-through hole (12) on the mesas (4);
- applying the wafer composite assembly comprising growth substrate wafer (20) and layer sequence to a carrier substrate wafer (21) in such a way that the mesas (4) face the carrier substrate wafer (21), and connecting the wafer composite assembly to the carrier substrate wafer (21), in particular by means of soldering or adhesive bonding;
- completely removing the growth substrate wafer (20);
- applying an electrical contact-connection (7, 43, 49) to the opposite side of the layer sequence relative to the mesas (4); and
- singulating the wafer composite assembly comprising carrier substrate wafer (21) and structured layer sequence along separating tracks (22) to form semiconductor chips (23).

## Revendications

1. Puce de semi-conducteur pour l'optoélectronique, notamment puce de semi-conducteur émettant un rayonnement, avec
une couche à film mince active (2), dans laquelle est formée une zone (3) d'émission de photons ; et
- un substrat de support (1) pour la couche à film mince (2), lequel substrat est disposé sur une face de la couche à film mince (2) orientée à l'opposé de la direction de rayonnement de la puce, et est assemblé à ladite couche,
- au moins une cavité (8) étant formée dans la couche à film mince active (2) dès le substrat de support (1), par laquelle une multiplicité de mésas (4) sont formées à la frontière entre substrat de support (1) et couche à film mince (2), et
- l'au moins une cavité (8) étant formée avec une telle profondeur qu'elle sépare la zone active (3), **caractérisée en ce que**
- un substrat de croissance (20) est enlevé de la couche à film mince active (2).

2. Puce de semi-conducteur selon la revendication 1, dans laquelle
- la section transversale de la cavité (8) diminue en s'éloignant du substrat de support (1).

3. Puce de semi-conducteur selon l'une quelconque des revendications précédentes, dans laquelle
- des mesas (4) sont formées par une multiplicité de cavités (8), uniquement dans des régions qui représentent des régions d'émission de rayonnement de la couche à film mince (2).

4. Puce de semi-conducteur selon l'une quelconque des revendications précédentes, dans laquelle
- au moins une trajectoire (18) des photons émis par la zone active (3) conduit de la mésa respective (4) jusqu'à une des mésas voisines (4).

5. Puce de semi-conducteur selon l'une quelconque des revendications précédentes, dans laquelle
- les mésas (4) se rétrécissent en direction du substrat de support.

6. Puce de semi-conducteur selon l'une quelconque des revendications précédentes, dans laquelle
- les mésas (4) présentent des faces latérales concaves (13).

7. Puce de semi-conducteur selon l'une quelconque des revendications précédentes, dans laquelle
- la couche de recouvrement (5) est autant transparente que possible pour les photons émis par la zone active (3).

8. Puce de semi-conducteur selon l'une quelconque des revendications précédentes, dans laquelle
- les mésas (4) sont recouvertes d'une couche de réflexion (9, 10).

9. Puce de semi-conducteur selon l'une quelconque des revendications précédentes, dans laquelle
- la couche de réflexion présente une couche de métallisation (10) avec une couche d'isolation sous-jacente (9).

10. Puce de semi-conducteur selon l'une quelconque des revendications précédentes, dans laquelle
- la couche à film mince active (2) présente une épaisseur comprise entre 5 µm et 25 µm.

11. Puce de semi-conducteur selon l'une quelconque des revendications précédentes, dans laquelle
- la profondeur de ladite au moins une cavité (8) est plus grande que la moitié de l'épaisseur de la couche à film mince (2).

12. Puce de semi-conducteur selon l'une quelconque des revendications précédentes, dans laquelle
- la surface (6) de la couche à film mince (2) qui fait face au côté de fixation (11) est munie d'une couche antireflet optique (42) pour la sortie améliorée de la lumière, et
- la couche antireflet optique (42) est formée de nitrure de silicium ou d'oxyde d'indium-étain conducteur.

13. Puce de semi-conducteur selon l'une quelconque des revendications précédentes, dans laquelle
- la couche à film mince (2) ne présente aucune cavité (8) dans la région située en face d'un ou de plusieurs point(s) de contact (7, 43).

14. Puce de semi-conducteur selon l'une quelconque des revendications précédentes, dans laquelle
- les mésas (4) présentent une forme de tronc de pyramide ou de tronc de cône et les faces latérales inclinées présentent un angle d'inclinaison ϕ compris entre 5° et 60°, notamment entre 10° et 40°, notamment entre 15° et 30°, par rapport à la direction d'extension latérale de la couche à film mince (2).

15. Procédé pour la fabrication simultanée d'une multiplicité de puces de semi-conducteur pour l'optoélectronique avec une couche à film mince active (2), dans laquelle est formée une zone active (3) d'émission de photons, comprenant les étapes de procédé suivantes:
- croissance épitaxiale d'une succession de couches contenant la zone d'émission de photons (3) sur une galette de substrat de croissance (20);
- formation d'au moins une cavité (8) dans la succession de couches, de telle manière qu'il apparaisse une multiplicité de mésas (4) dans la succession de couches;
- dépôt d'au moins une couche d'isolation (9) sur la surface de la succession de couches munie des cavités (8) ;
- réalisation respectivement d'au moins un contact traversant (12) sur les mésas (4) ;
- dépôt du composite de tranches composé de la galette de substrat de croissance (20) et de la succession de couches sur une galette de substrat de support (21), de telle manière que les mésas (4) soient tournées vers la galette de substrat de support (21), et liaison du composite de tranches avec la galette de substrat de support (21), notamment par brasage ou collage;
- enlèvement complet de la galette de substrat de croissance (20);
- dépôt d'un contact électrique (7, 43, 49) sur le côté de la succession de couches qui fait face aux mésas (4); et
- séparation du composite de galette composé de la galette de substrat de support (21) et de la succession de couches structurée le long de traces de séparation (22) en puces de semi-conducteur (23).
